(19) Europäisches Patentamt
European Patent Office
Office européen des brevets

(11) Veröffentlichungsnummer : **0 457 722 A2**

(12) # EUROPÄISCHE PATENTANMELDUNG

(21) Anmeldenummer : **91810347.4**

(51) Int. Cl.$^5$ : **C08L 63/00**, C08L 79/08

(22) Anmeldetag : **07.05.91**

(30) Priorität : **15.05.90 CH 1639/90**

(43) Veröffentlichungstag der Anmeldung :
**21.11.91 Patentblatt 91/47**

(84) Benannte Vertragsstaaten :
**AT BE CH DE ES FR GB IT LI NL SE**

(71) Anmelder : **CIBA-GEIGY AG**
**Klybeckstrasse 141**
**CH-4002 Basel (CH)**

(72) Erfinder : **Pfaendner, Rudolf, Dr.**
**Sackgasse 3**
**W-6149 Rimbach/Odenwald 1 (DE)**
Erfinder : **Kainmüller, Thomas, Dr.**
**Am Kümmelberg 1**
**W-6145 Lindenfels 1 (DE)**
Erfinder : **Diethelm, Hermann, Dr.**
**Grottenweg**
**CH-1735 Giffers (CH)**
Erfinder : **Scharf, Wolfgang, Dr.**
**Röttler Ring 11 c**
**W-7889 Grenzach-Wyhlen (DE)**
Erfinder : **Haug, Theobald, Dr.**
**Untere Flühackerstrasse 12**
**CH-4402 Frenkendorf (CH)**

(54) **Gemische aus Epoxidharzen und Polyamid-Polyimid Blockcopolymeren.**

(57) Gemische, enthaltend
(a) ein Epoxidharz mit mindestens zwei Epoxidgruppen im Molekül und
(b) ein in einem polaren aprotischen Lösungsmittel lösliches Polyamid-Polyimid(PA-PI)-Blockcopolymer in einem Gewichtsverhältnis von a:b von 1:1 bis 1:200, eignen sich zur Herstellung von lösungsmittelbeständigen Beschichtungen und Verklebungen, insbesondere zur Herstellung von flexiblen Laminaten.

EP 0 457 722 A2

Die vorliegende Erfindung betrifft Gemische, enthaltend ein Epoxidharz und ein lösliches Polyamid-Polyimid(PA-PI)-Blockcopolymer, die aus diesen Gemischen hergestellten Laminate, Beschichtungen, Folien oder Verklebungen, insbesondere verklebten Metallfolien.

PA-PI-Blockcopolymere sind Werkstoffe mit sehr guten mechanischen und thermischen Eigenschaften, die unter anderem zur Beschichtung von Metallfolien verwendet werden. Eine wesentliche Eigenschaft dieser sogenannten flexiblen Laminate ist es, dass diese Materialien sehr oft gefaltet werden können, bevor es zu einem Bruch kommt. Derartige flexible Laminate sind beispielsweise im EP-Patent 48219 beschrieben. Die dort verarbeiteten Polymeren werden als Polyamid-Polyamidsäure-Lösung aufgebracht und nach der Beschichtung durch Wasserabspaltung thermisch in die unlösliche Polyamid-Polyimidform übergeführt. Dieser Reaktionsschritt kann jedoch zu unerwünschten Begleiterscheinungen, wie Blasenbildung und Molekulargewichtsabbau führen. Darüber hinaus ist die eingesetzte Polyamid-Polyamidsäure-Lösung nicht lagerstabil.

Deshalb ist es vorteilhaft, bei diesen Beschichtungen lösliche PA-PI-Blockcopolymere einzusetzen, wie sie beispielsweise aus der EP-A-324 315 oder der DE-OS 37 38 458 bekannt sind. Diese löslichen Polymeren sind nach Applikation aber empfindlich gegenüber den verwendeten Lösungsmitteln. Lösungsmittelstabile Polymere können bei bestimmten Zusammensetzungen durch eine thermische Nachbehandlung erhalten werden, die aber unter Umständen hohe Temperaturen und/oder lange Reaktionszeiten erfordert.

Es wurde nun gefunden, dass ein Gemisch, enthaltend ein Epoxidharz mit mindestens zwei Epoxidgruppen im Molekül und ein lösliches PA-PI-Blockcopolymer nach der Applikation in kurzer Zeit bei verhältnismässig niedrigen Reaktionstemperaturen eine lösungsmittelstabile Beschichtung liefert, wobei gleichzeitig die guten mechanischen Eigenschaften des Polymeren weitestgehend erhalten bleiben.

Gegenstand vorliegender Erfindung sind somit Gemische, enthaltend

(a) ein Epoxidharz mit mindestens zwei Epoxidgruppen im Molekül und

(b) ein in einem polaren aprotischen Lösungsmittel lösliches Polyamid-Polyimid(PA-PI)-Blockcopolymer in einem Gewichtsverhältnis von a:b von 1:1 bis 1:200.

Hier und im folgenden sind unter PA-PI-Blockcopolymeren Verbindungen zu verstehen, die aus Polyamid- und Polyimidblöcken, aus Polyamidimid- und Polyimidblöcken oder aus Polyamid-, Polyamidimid- und Polyimidblöcken aufgebaut sind.

Vorzugsweise liegt im erfindungsgemässen Gemisch ein Gewichtsverhältnis von a:b von 1:4 bis 1:100, insbesondere 1:5 bis 1:50, besonders bevorzugt von 1:15 bis 1:40, vor.

In diesen Gemischen einsetzbare Epoxidharze sind vorzugsweise solche mit mindestens zwei direkt an ein Sauerstoff-, Stickstoff- oder Schwefelatom bzw. -atome gebundenen Gruppen der Formel I

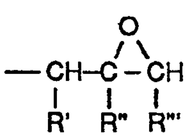 (I),

worin entweder R′ und R‴ je ein Wasserstoffatom darstellen, wobei R″ dann ein Wasserstoffatom oder eine Methylgruppe bedeutet, oder R′ und R‴ zusammen $-CH_2CH_2-$ darstellen, wobei R″ dann ein Wasserstoffatom bedeutet.

Als Beispiele solcher Harze seien Polyglycidyl- und Poly-(β-methylglycidyl)-ester genannt, die man durch Umsetzung einer zwei oder mehrere Carbonsäuregruppen pro Molekül enthaltenden Verbindung mit Epichlorhydrin, Glycerindichlorhydrin oder β-Methylepichlorhydrin in Gegenwart von Alkali erhalten kann. Solche Polyglycidylester können sich von aliphatischen Polycarbonsäuren, z.B. Oxalsäure, Bernsteinsäure, Glutarsäure, Adipinsäure, Pimelinsäure, Korksäure, Azelainsäure, Sebacinsäure, oder dimerisierter oder trimerisierter Linolsäure, von cycloaliphatischen Polycarbonsäuren, wie Tetrahydrophthalsäure, 4-Methyltetrahydrophthalsäure, Hexahydrophthalsäure und 4-Methylhexahydrophthalsäure, sowie von aromatischen Polycarbonsäuren, wie Phthalsäure, Isophthalsäure und Terephthalsäure, ableiten.

Weitere Beispiele sind Polyglycidyl- und Poly-(β-methylglycidyl)-ether, die durch Umsetzung einer mindestens zwei freie alkoholische und/oder phenolische Hydroxylgruppen pro Molekül enthaltenden Verbindung mit dem entsprechenden Epichlorhydrin unter alkalischen Bedingungen, oder auch in Gegenwart eines sauren Katalysators mit nachfolgender Alkalibehandlung, erhältlich sind. Diese Ether lassen sich aus acyclischen Alkoholen, wie Ethylenglykol, Diethylenglykol und höheren Poly-(oxyethylen)-glykolen, Propan-1,2-diol und Poly-(oxypropylen)-glykolen, Propan-1,3-diol, Butan-1,4-diol, Poly-(oxytetramethylen)-glykolen, Pentan-1,5-diol, Hexan-1,6-diol, Hexan-2,4,6-triol, Glycerin, 1,1,1-Trimethylolpropan, Pentaerythrit, Sorbit und Polyepichlorhydrinen, aus cycloaliphatischen Alkoholen, wie Resorcit, Chinit, Bis-(4-hydroxycyclohexyl)-methan, 2,2-Bis-(4-hydroxycyclohexyl)-propan und 1,1-Bis-(hydroxymethyl)-3-cyclohexen, und aus Alkoholen mit aromatischen

Kernen, wie N,N-Bis-(2-hydroxyethyl)-anilin und p,p'-Bis-(2-hydroxyethylamino)-diphenylmethan, herstellen. Man kann sie ferner aus einkernigen Phenolen, wie Resorcin und Hydrochinon, und mehrkernigen Phenolen, wie Bis-(4-hydroxyphenyl)-methan, 4,4'-Dihydroxydiphenyl, Bis-(4-hydroxyphenyl)-sulfon, 1,1,2,2-Tetrakis-(4-hydroxyphenyl)-ethan, 2,2-Bis-(4-hydroxyphenyl)-propan und 2,2-Bis-(3,5-dibrom-4-hydroxyphenyl)-propan, sowie aus Aldehyden, wie Formaldehyd, Acetaldehyd, Chloral und Furfural, mit Phenolen, wie Phenol selbst und durch Chloratome oder Alkylgruppen mit jeweils bis zu 9 Kohlenstoffatomen ringsubstituiertem Phenol, wie 4-Chlorphenol, 2-Methylphenol und 4-tert.-Butylphenol, gebildeten Novolaken herstellen.

Poly-(N-glycidyl)-verbindungen umfassen beispielsweise solche, die durch Dehydrochlorierung der Umsetzungsprodukte von Epichlorhydrin mit mindestens zwei Aminwasserstoffatome enthaltenden Aminen, wie Anilin, n-Butylamin, Bis-(4-aminophenyl)-methan, m-Xylylendiamin und Bis-(4-methylaminophenyl)-methan, erhalten werden, Triglycidylisocyanurat, sowie N,N'-Diglycidylderivate von cyclischen Alkylenharnstoffen, wie Ethylenharnstoff und 1,3-Propylenharnstoff, und von Hydantoinen, wie 5,5-Dimethylhydantoin.

Poly-(S-glycidyl)-verbindungen sind zum Beispiel die Di-S-glycidylderivate von Dithiolen, wie Ethan-1,2-dithiol und Bis-(4-mercaptomethylphenyl)-ether.

Beispiele für Epoxidharze mit Gruppen der Formel I, worin R' und R''' zusammen eine $-CH_2CH_2-$Gruppe bedeuten, sind Bis-(2,3-epoxycyclopentyl)-ether, 2,3-Epoxycyclopentyl-glycidylether, 1,2-Bis-(2,3-epoxycyclopentyloxy)-ethan, Bis-(3,4-epoxycyclohexylmethyl)-adipat oder 3,4-Epoxycyclohexylmethyl-3,4-epoxycyclohexancarboxylat.

In Betracht kommen auch Epoxidharze, in welchen die 1,2-Epoxidgruppen an Heteroatome verschiedener Art gebunden sind, beispielsweise das N,N,O-Triglycidylderivat des 4-Aminophenols oder des 2,2-(4-Aminophenyl-4'-hydroxyphenyl)-propans, der Glycidylether/Glycidylester der Salicylsäure, N-Glycidyl-N'-(2-glycidyloxypropyl)-5,5-dimethylhydantoin und 2-Glycidyloxy-1,3-bis-(5,5-dimethyl-1-glycidylhydantoin-3-yl)propan. Die verwendeten Epoxidharze können auch durch Alkyle, Alkenyle, Aryle, Halogenatome, Aryloxy oder Alkoxy substituiert sein. Ein bevorzugtes Beispiel dafür ist der o,o'-Diallylbisphenol A-diglycidylether.

Gewünschtenfalls kann ein Gemisch aus Epoxidharzen verwendet werden.

Bevorzugte Epoxidharze sind Polyglycidylether von Phenolen oder Novolaken, Triglycidylisocyanurat, N,N,O-Triglycidyl-p-aminophenol, Poly-(N-glycidyl)-derivate aromatischer Amine und cycloaliphatische Epoxidharze. Speziell bevorzugte Harze sind die Diglycidylether von Bisphenolen, wie 2,2-Bis-(4-hydroxyphenyl)-propan (Bisphenol A), Bisphenol S und Bis-(4-hydroxyphenyl)-methan (Bisphenol F) oder Novolaken, o,o'-Diallylbisphenol A-diglycidylether, Triglycidylisocyanurat, N,N,O-Triglycidyl-p-aminophenol, Bis-[4-(diglycidylamino)-phenyl]-methan, Tetra-(p-glycidyloxyphenyl)-ethan und 3,4-Epoxycyclohexylmethyl-3,4-epoxycyclohexancarboxylat.

Unter dem Begriff "lösliches PA-PI-Blockcopolymeres" ist im allgemeinen ein in polaren aprotischen Lösungsmitteln lösliches Copolymer zu verstehen, aus dem sich Lösungen enthaltend mindestens 5 Gew. %, insbesondere mindestens 10 Gew. %, an PA-PI-Blockcopolymer, bezogen auf die Lösung, herstellen lassen.

In einem polaren aprotischen Lösungsmittel lösliche PA-PI-Blockcopolymere (b) sind bekannt, beispielsweise aus der EP-A-324 315. Bevorzugt sind Blockcopolymere des Typs A mit einem mittleren Molekulargewicht $\overline{M}_n$ von 1'000 bis 50'000 und wiederkehrenden Einheiten der Formel II

$$\left[ PA-PI \right] \quad (II),$$

worin PA für einen Polyamidblock mit einem mittleren Molekulargewicht $\overline{M}_n$ von 300-20'000 steht, enthaltend mindestens eine (wiederkehrende) Einheit der Formel III

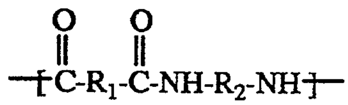 (III),

worin $R_1$ ein Rest der Formeln $-C_nH_{2n}-$, 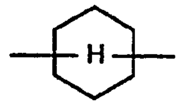 , 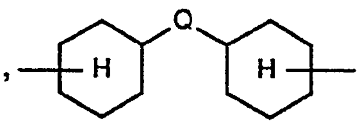 ,

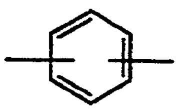 , 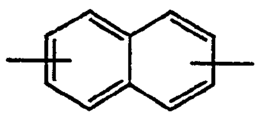 oder 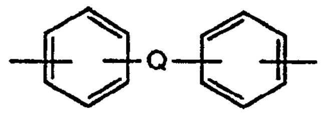 ist, und $R_2$ einen Rest der Formeln $-C_nH_{2n}-$, 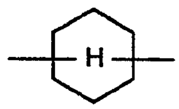 , 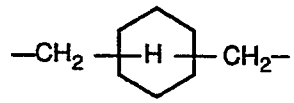 ,

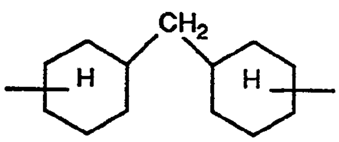 , 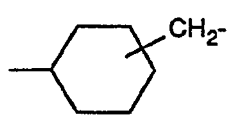 , 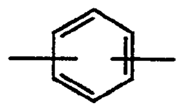 , 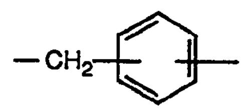 ,

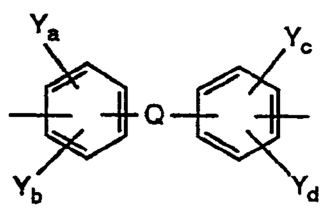 , 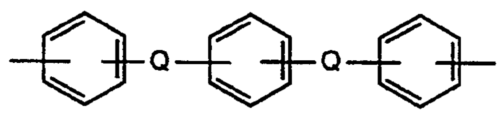 oder

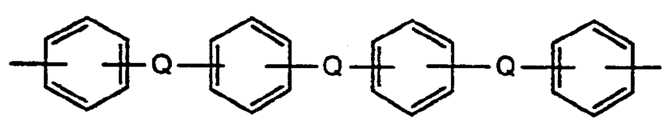 bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkyl bedeuten, und PI für einen Polyimidblock mit einem mittleren Molekulargewicht $\overline{M}_n$ von 300-20'000 steht, enthaltend mindestens eine (wiederkehrende) Einheit der Formel IV

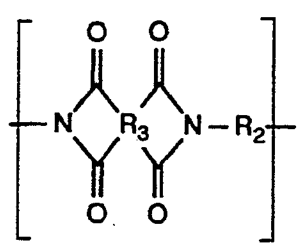 (IV),

worin $R_3$

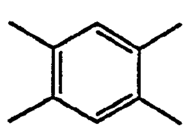 , 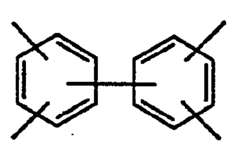 oder 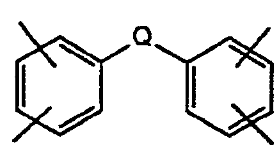

ist, und Q und $R_2$ die oben angegebene Bedeutung haben, mit der Massgabe, dass 25-100 Mol-% aller Brückenglieder $R_2$

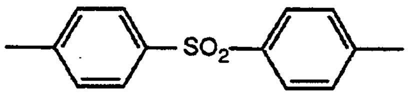

und/oder

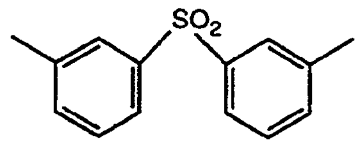

bedeuten, und der (cyclo-)aliphatische Anteil an Brückengliedem $R_2$ nicht mehr als 10 Mol-% beträgt.

Bevorzugte Blockcopolymere mit der wiederkehrenden Einheit der Formel II besitzen ein mittleres Molekulargewicht $\overline{M}_n$ von 4'000-40'000.

In bevorzugten Blockcopolymeren enthalten die Polyamidblöcke und/oder die Polyimidblöcke mehr als eine wiederkehrende Struktureinheit der Formel III bzw. der Formel IV. Dies ergibt für bevorzugte Polyamidblöcke bzw. Polyimidblöcke ein mittleres Molekulargewicht von 500-20'000.

In den obenstehenden Formeln bedeutet $R_1$ z.B. Phenylen-1,3; Phenylen-1,4; Naphthylen-1,5; Naphthylen-1,8; Biphenylen-3,3', Biphenylen-4,4'

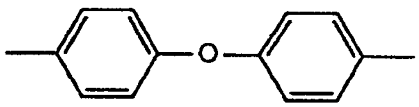

,

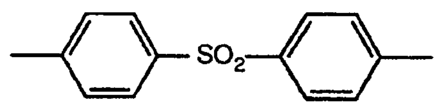

oder Butylen-1,4. Bevorzugt ist Phenylen-1,3.

$R_2$ in den Formeln III und/oder IV ist erfindungsgemäss dadurch charakterisiert, dass in 25-100 Mol-% und insbesondere 50-100 Mol-% der im Copolymeren vorkommenden Bückenglieder $R_2$ Gruppen der Formeln

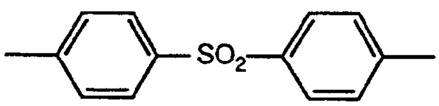

und/oder

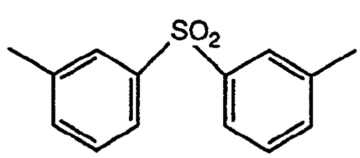

bedeuten. Dabei ist es nicht zwingend, dass sowohl Polyamid- als auch Polyimidblöcke solche Bückenglieder enthalten.

Bedeuten $R_1$ oder $R_2$ je eine Gruppe $-C_nH_{2n}-$, so handelt es sich beispielsweise um Ethylen-1,2; Propylen-1,3; Tetramethylen-1,4; Pentamethylen-1,5; Hexamethylen-1,6; Heptamethylen-1,7; Octamethylen-1,8; Nonamethylen-1,9; Decamethylen-1,10; Dodecamethylen-1,12; Decamethylen-2,9; oder 2-Methylpentamethylen-1,5.

Sind $R_1$ oder $R_2$ eine Gruppe

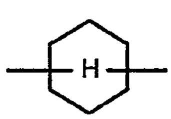

,

so kann es sich um Cyclohexylen-1,2; Cyclohexylen-1,3 oder Cyclohexylen-1,4 handeln.

Weitere Beispiele für spezifrsche cycloaliphatische Gruppen $R_2$ sind

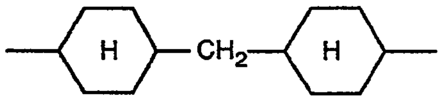 , 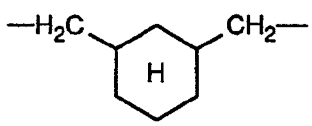 , 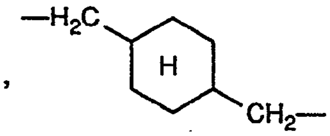 ,

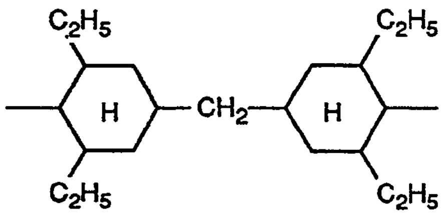 , 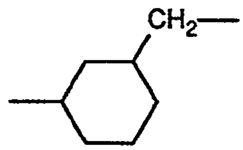 oder 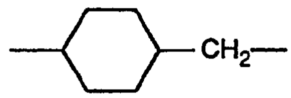 .

Beispiele für spezifische aromatische Gruppen $R_2$ sind Phenylen-1,2; Phenylen-1,3; Phenylen-1,4; Methylphenylen-2,4; 1,3,5-Trimethylphenylen-2,5; Xylylen-2,5; 4-Chlorphenylen-1,3; 2,5-Dichlorphenylen-1,4; oder eine der folgenden Gruppen

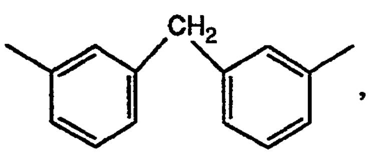 , 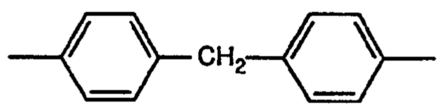 ,

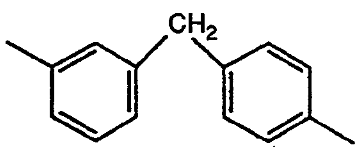 , 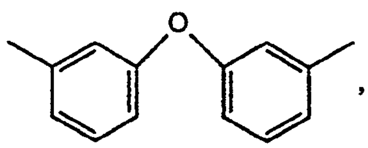 , 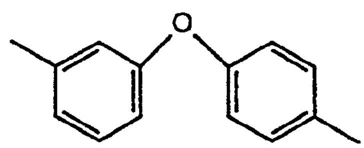 ,

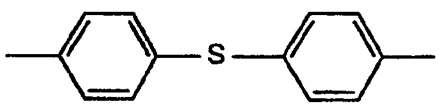 , 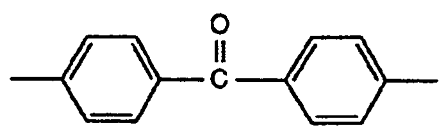 ,

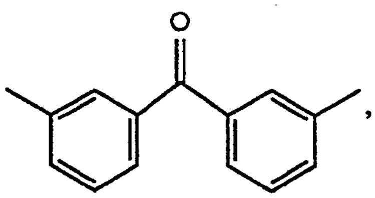 , 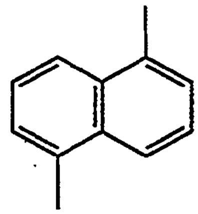 , 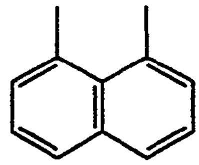 ,

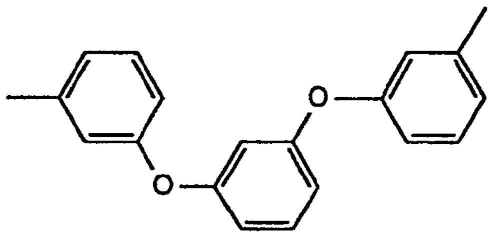 ,

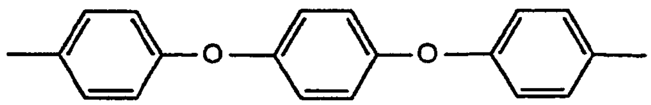 ,

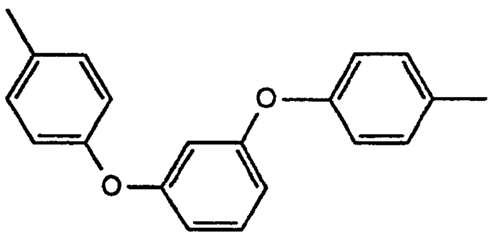 , 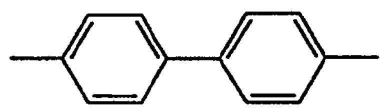 ,

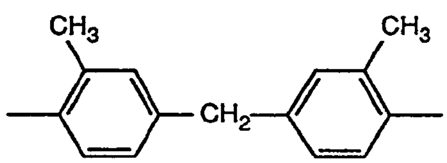 , 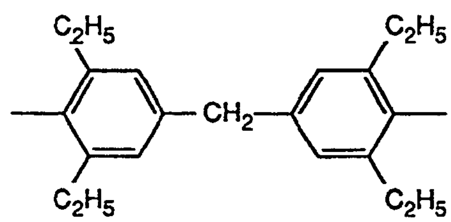 ,

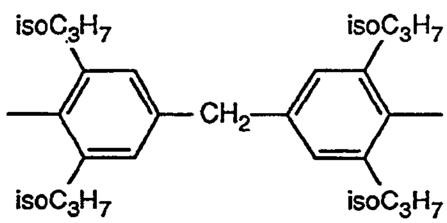 , 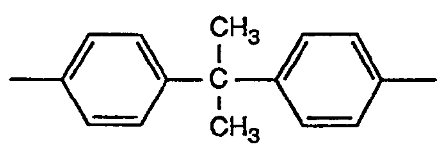 ,

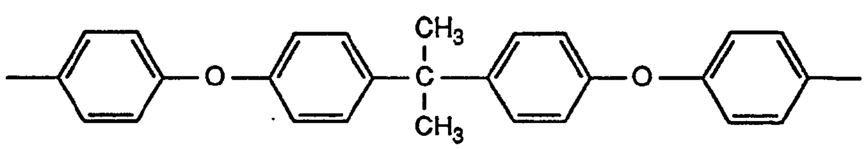 ,

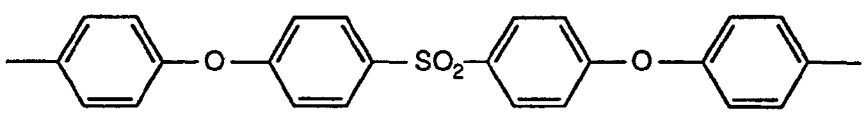 ,

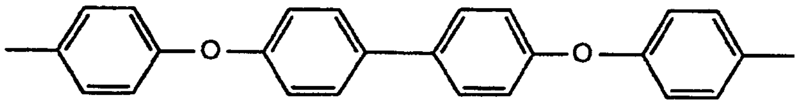 ,

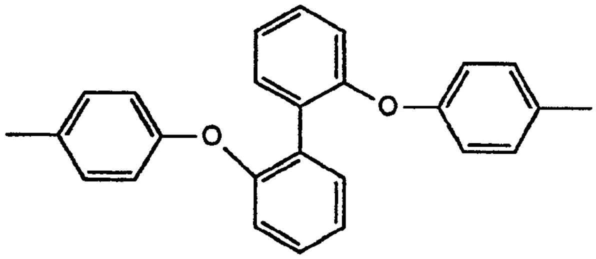 und insbesondere die Gruppen

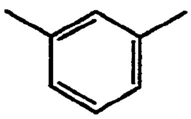 , 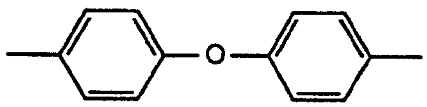 , 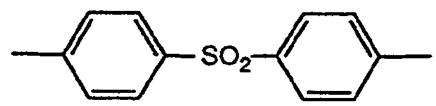

und 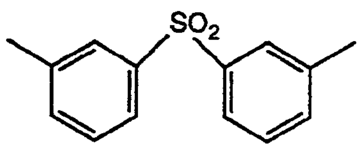 für $R_2$ in der Formel III, und die Gruppen

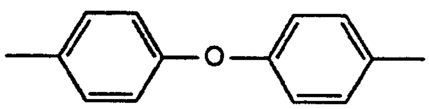 , 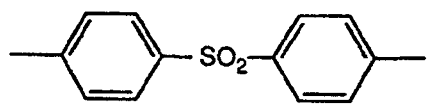 und

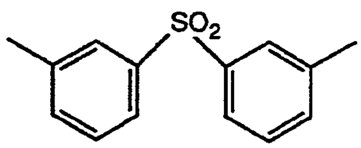 für $R_2$ in der Formel IV.

Enthalten die Brückenglieder $R_2$ einen zweiwertigen Rest Q, so handelt es sich beispielsweise um $-CH_2CH_2-$ und -S-, und bevorzugt um $-CH_2-$,

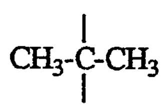 , -O-,

$-SO_2-$ oder -C(O)-. Enthält ein Bückenglied $R_2$ mehrere Rest Q, so können diese gleich oder verschieden sein.

Der vierwertige Rest $R_3$ leitet sich von einer Tetracarbonsäure ab, die fähig ist, ein Dianhydrid zu bilden. Es handelt sich dabei z.B. um Gruppen

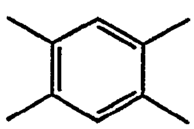 , 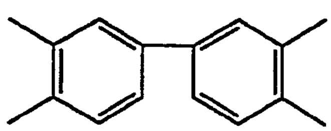 , 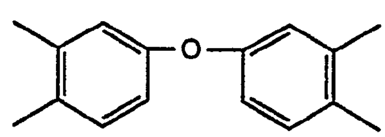 ,

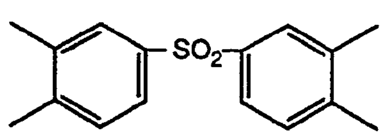 oder 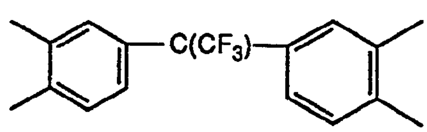

und insbesondere um

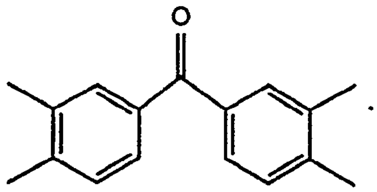

Beispiele für mögliche Kombinationen von Polyamid- und Polyimidblöcken zu PA-PI-Blockcopolymeren des Typs A sind in Tabelle I angegeben. Diese PA-PI-Blockcopolymeren können gemäss Beispiel 1 des EP-A-0 324 315 hergestellt werden.

Tabelle I: PA-PI-Blockcopolymere A

| PI - Block | | PA - Block | | Viskosität η inh. [dl/g] | | Löslichkeit in NMP [%] nach Trocken-temp. von 240°C |
|---|---|---|---|---|---|---|
| Tetracarbonsäure-dianhydrid | Diamin | Dicarbonsäure-dichlorid | Diamin | PA-PAS | PA-PI | |
| BTDA 0,0920 | mDDS/pDDS 0,0395/0,0395 | IPC 0,1625 | mDDS/pDDS 0,0855/0,0855 Mol | 0,57 | 0,63 | 42 |
| BTDA 0,0726 | pDDS 0,0622 | IPC 0,109 | pDDS 0,1209 Mol | 0,51 | 0,46 | 35 |
| BTDA 0,1440 | pDDS/DDE 0,1111/0,0123 | IPC 0,2507 | pDDS/DDE 0,2401/0,0267 Mol | 1,37 | 0,51 | 17 |
| BTDA 0,0937 | pDDS 0,0854 | IPC 0,1038 | mPDA 0,1109 Mol | 0,43 | 0,34 | 40 |
| BTDA 0,0978 | pDDS 0,0838 | IPC 0,0852 | pDDS 0,979 Mol | 0,60 | 0,73 | 35 |
| BTDA 0,822 | pDDS 0,0740 | IPC 0,0253 | pDDS 0,03312 Mol | 0,46 | 0,36 | 30 |
| BTDA 0,1192 | pDDS 0,0894 | IPC 0,3620 | pDDS 0,3876 Mol | 0,96 | 0,66 | 35 |
| BTDA 0,3445 | pDDS 0,2953 | IPC 0,5915 | mDDS 0,640 | 0,99 | 0,74 | 20 |
| BTDA/PMDA 0,1391/0,1398 | pDDS 0,2391 | IPC 0,4803 | pDDS 0,5189 Mol | 0,41 | 0,31 | 30 |

Tabelle I: (Fortsetzung)

| PI - Block | | PA - Block | | Viskosität $\eta$ inh. [dl/g] | | Löslichkeit in NMP [%] nach Trocken-temp. von 240°C |
|---|---|---|---|---|---|---|
| Tetracarbonsäure-dianhydrid | Diamin | Dicarbonsäure-dichlorid | Diamin | PA-PAS | PA-PI | |
| BTDA 0,1439 | pDDS 0,1241 | IPC 0,2530 | pDDS 0,2674 Mol | 0,43 | 0,36 | 35 |
| BTDA 0,2123 | pDDS 0,0592<br>mDDS 0,0591<br>pDDS 0,0591 | IPC 0,326 | pDDS 0,1181 Mol<br>mDDS 0,1181 Mol<br>mBAPB 0,1181 Mol | 0,86 | 0,69 | 35 |

BTDA: 3,3'-4,4'-Benzophenontetracarbonsäuredianhydrid
PMDA: Pyromellitsäuredianhydrid
pDDS: 4,4'-Diaminodiphenylsulfon
IPC: Isophthalsäuredichlorid
mDDS: 3,3'-Diaminodiphenylsulfon
DDE: 4,4'-Diaminodiphenylether
mBAPB: 1,3-Bis-(3-aminophenoxy)benzol
mPDA: m-Phenylendiamin
NMP: N-Methylpyrrolidon
Viskosität: 0,5 Gew.-% Polymeres in NMP bei 25°C
PA-PAS: Polyamid-Polyamidsäure

Weitere geeignete, in polaren aprotischen Lösungsmitteln lösliche PA-PI-Blockcopolymere vom Typ B mit wiederkehrenden Einheiten der Formel II und einem mittleren Molekulargewicht $\overline{M}_n$ von 1'000 bis 50'000 sind dadurch gekennzeichnet, dass diese ein Verhältnis von Amid- zu Imidgruppen von etwa 4:1 bis 1:4 aufweisen und dass diese Polymeren in den Polyimidblöcken einen Gehalt von mindestens 2 Mol.%, insbesondere von mindestens 5 Mol%, bezogen auf den Gehalt an allen Carbonsäureresten im Copolymeren, an Resten der Formel

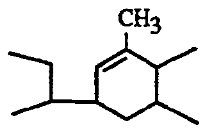

(DMCD Reste), die sich von 5-(2,5-Diketotetrahydrofurfuryl)-3-methylcyclohexen-1,2-dicarbonsäure ableiten, aufweisen.

Der Gehalt an DMCD Resten in den erfindungsgemäss verwendbaren PA-PI-Blockcopolymeren beträgt in der Regel 2 bis 80 Mol%, bezogen auf den Gehalt an allen Carbonsäureresten im Copolymeren.

Bevorzugte PA-PI-Blockcopolymere enthalten Kombinationen von Blöcken der Formeln Vb mit IVa und/oder IVc oder der Formeln IVb mit Va und/oder Vc

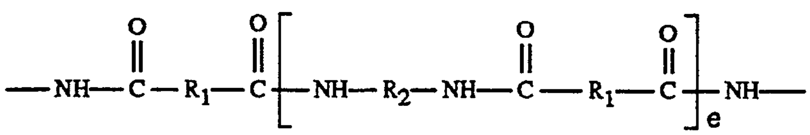 (IVa),

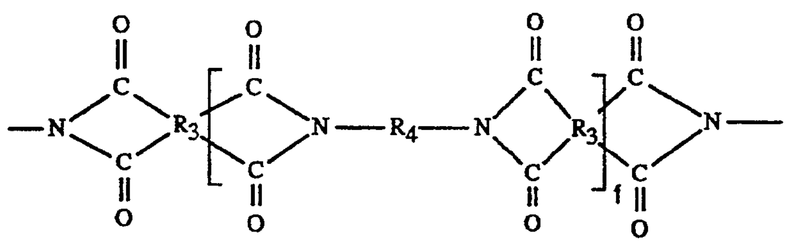 (IVb),

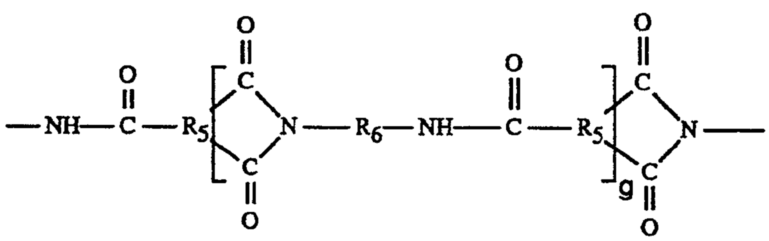 (IVc),

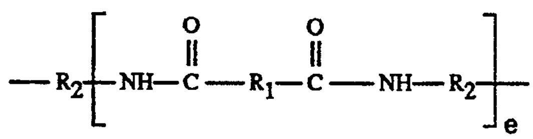 (Va),

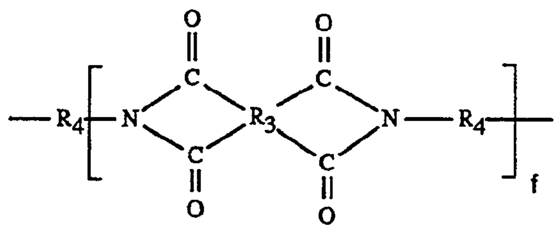 (Vb),

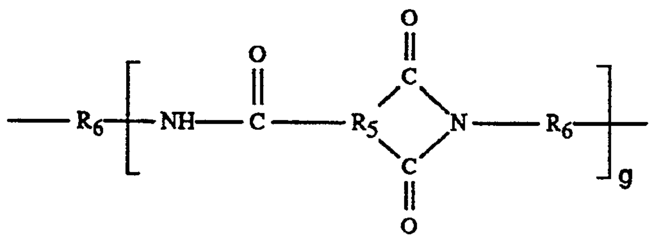 (Vc),

worin die Indizes e, f und g unabhängig voneinander ganze Zahlen von 1 bis 100 sind, $R_1$ und $R_2$ die gleiche Bedeutung wie in Formel III haben, $R_3$ ein Rest der Formeln

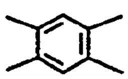 , 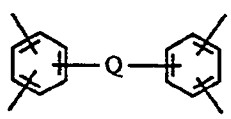 , 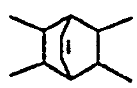 , 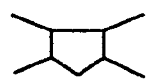 oder 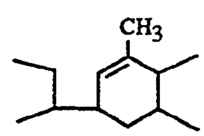 ist,

worin Q eine direkte Bindung darstellt oder $-CH_2-$, $-CH_2CH_2-$, $-CH(CH_3)-$, $-C(CH_3)_2-$, $-C(CF_3)_2-$, -O-, -S-, $-SO_2-$ oder -CO- bedeutet, $R_5$ ein Rest der Formel

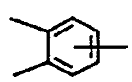

ist, und $R_4$ und $R_6$ unabhängig voneinander eine der für $R_2$ definierten Bedeutungen besitzen, mit der Massgabe, dass 25-100 Mol % aller Reste $R_3$ die Formel

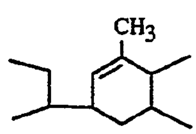

aufweisen.

In den Formeln IVa und Va haben $R_1$ und $R_2$ die gleiche bevorzugte Bedeutung wie in Formel III.

Der vierwertige Rest $R_3$ leitet sich von einer Tetracarbonsäure ab, die in der Lage ist, ein Dianhydrid zu bilden.

Dabei handelt es sich bevorzugt um Reste der Formeln

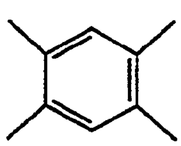 , 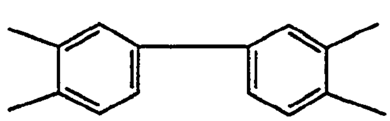 , 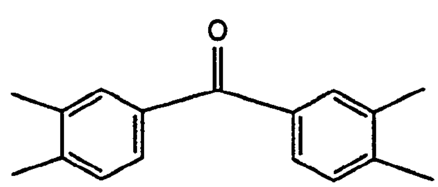 ,

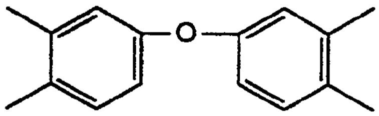 , 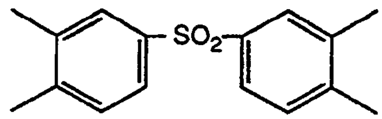 oder

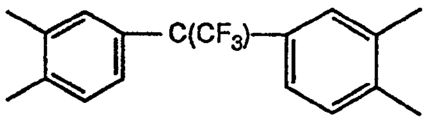 und ganz besonders 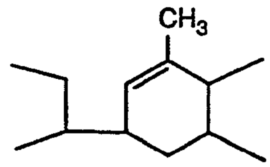 .

Der Anteil der DMCD Reste in den Polyimidblöcken der erfindungsgemäss zu verwendenden Blockcopolymeren beträgt vorzugsweise 50 bis 100 Mol %, bezogen auf den Anteil der Tetracarbonsäurereste in diesen Blöcken.

$R_5$ ist vorzugsweise ein Rest der Formel

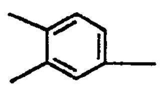 .

Mögliche Kombinationen von Polyamid- mit Polyimidblöcken zu PA-PI-Blockcopolymeren des Typs B sind in Tabelle II angegeben. Diese Blockcopolymeren können beispielsweise in an sich bekannter Weise durch Umsetzung vorgeformter Polyamid- und Polyamidsäureblöcke und anschliessende Cyclisierung der Polyamid-Polyamidsäure erhalten werden.

Tabelle II: PA-PI-Blockcopolymere B

| PI - Block Tetracarbonsäure-dianhydrid (Mol) | PI - Block Diamin (Mol) | PA - Block Dicarbonsäure-dichlorid (Mol) | PA - Block Diamin (Mol) | η inh [dl/g] PA-PAS | η inh [dl/g] PA-PI | Löslichkeit in NMP [%] nach Trocken-temp. von 240°C |
|---|---|---|---|---|---|---|
| DMCD (0,2676) | DDE (0,2295) | IPC (0,4645) | mPDA (0,4980) | 1,01 | 0,67 | > 30 |
| DMCD (0,2500) | mDDS (0,1042) pDDS (0,1042) | IPC (0,3775) | mDDS (0,2084) pDDS (0,2084) | 0,46 | 0,40 | > 30 |
| DMCD (0,2404) | Diamingemisch (0,2004) | IPC (0,3657) | Diamingemisch (0,4037) | 0,59 | 0,52 | > 30* |
| DMCD (0,1052) BTDA (0,1052) | mXDA (0,091) pDDS (0,0917) | IPC (0,3657) | mPDA (0,3926) | 0,63 | 0,35 | > 30 |
| DMCD (0,1250) | DDE (0,1042) | IPC (0,1877) | DDE (0,2084) | 1,66 | 1,06 | >30 |

* Trockentemperatur 200°C

DMCD: 5-(2,5-Dioxotetrahydrofurfuryl)-3-methyl-3-cyclohexen-1,2-dicarbonsäureanhydrid
BTDA: 3,3',4,4'-Benzophenontetracarbonsäuredianhydrid
IPC: Isophthalsäuredichlorid    DDE: 4,4'-Diaminodiphenylether
pDDS: 4,4'-Diaminodiphenylsulfon    mDDS: 3,3'-Diaminodiphenylsulfon
mPDA: m-Phenylendiamin    mXDA: m-Xylylendiamin

Diamingemisch: technisches Produkt bestehend aus 4,4'-Diaminodiphenylmethan, 3-Ethyl-4,4'-Diaminodiphenylmethan, 3,3'-Diethyl-4,4'-Diaminodiphenylmethan (aus Aminzahl berechnetes durchschnittliches Molekulargewicht: 232)

Inhärente Viskosität: 0,5 Gew.-% Polymeres in NMP bei 25°C
PA-PAS: Polyamid-Polyamidsäure

Ebenfalls geeignete, in polaren aprotischen Lösungsmitteln lösliche PA-PI-Blockcopolymere vom Typ C mit einem durchschnittlichen Molekulargewicht $\overline{M}_n$ von 1'000 bis 50'000 enthalten die Kombination von Blöcken der Formeln IVa mit Vb und/oder Vc oder der Formeln IVb mit Va und/oder Vc oder der Formeln IVc mit Va und/oder Vb, mit der anderen Massgabe, dass 10-100 Mol %, bevorzugt 25-100 Mol %, insbesondere 50-100 Mol %, aller Reste $R_2$, $R_4$ und $R_6$, bezogen auf die Gesamtmenge dieser Reste, die Formel

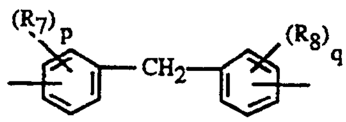

aufweisen, worin p 1 oder 2 und q

Null, 1 oder 2 ist, $R_7$ und $R_8$ je ein $C_1$-$C_8$-Alkyl bedeuten oder worin je zwei zueinander ortho-ständige Reste $R_7$ und $R_8$ jeweils zusammen eine Alkylengruppe bilden.

Ein Alkylsubstituent $R_7$ oder $R_8$ in der oben angegebenen Formel kann verzweigt oder bevorzugt geradkettig sein. Bevorzugt wird geradkettiges $C_1$-$C_6$Alkyl. Beispiele dafür sind Methyl, Ethyl, n-Propyl, n-Butyl, n-Pentyl und n-Hexyl. Besonders bevorzugt werden Methyl und Ethyl.

Bilden die Reste $R_7$ oder $R_8$ zusammen eine Alkylenkette, so handelt es sich dabei vorzugsweise um Tri- oder insbesondere um Tetramethylen.

Das bevorzugte Verhältnis von Amidgruppen zu Imidgruppen in den zu verwendenden PA-PI-Blockcopolymeren beträgt 4:1 bis 1:4.

Die mittleren Molekulargewichte $\overline{M}_n$ in den Polyamidblöcken IVa und Va oder in den Polyimidblöcken IVb und Vb oder in den Polyamidimidblöcken IVc und Vc der PA-PI-Blockcopolymeren C betragen im allgemeinen 300 bis 20'000, vorzugsweise 500 bis 10'000.

Neben den oben erwähnten Kombinationen von zwei Blöcken können die erfindungsgemäss zu verwendenden PA-PI Blockcopolymeren C auch Dreiblockkombinationen der Formeln IVa, IVb und Vc oder der Formeln IVa, IVc und Vb oder der Formeln IVb, IVc und Va enthalten.

Bevorzugt verwendet man PA-PI Blockcopolymere C, die im wesentlichen aus Polyamidblöcken IVa und Polyimidblöcken IVb oder aus Polyamidblöcken Va und Polyimidblöcken IVb bestehen.

Die Herstellung dieser erfindungsgemäss zu verwendenden PA-PI-Blockcopolymere C kann ebenfalls in an sich bekannter Weise durch Umsetzung vorgeformter Polyamid- und Polyamidsäureblöcke und anschliessende Cyclisierung der Polyamid-Polyamidsäure erfolgen.

Beispiele für mögliche Kombinationen von Polyamid- mit Polyimidblöcken zu PA-PI-Blockcopolymeren C sind in folgender Tabelle III angegeben.

In der Tabelle III werden die folgenden Abkürzungen verwendet:

| | |
|---|---|
| $\eta_{inh}$ | : Inhärente Viscosität gemessen an einer 0,5 gew.%igen Lösung des Polymeren bei 25°C (in NMP), |
| BTDA | : 3,3',4,4'-Benzophenontetracarbonsäuredianhydrid, |
| BPDA | : 3,3',4,4'-Biphenyltetracarbonsäuredianhydrid, |
| IPC | : Isophthalsäuredichlorid, |
| TMAC | : Trimellitsäureanhydridchlorid, |
| BADM | : Bis-(3,5-diethyl-4-aminophenyl)-methan, |
| BEMA | : Bis-(3-ethyl-5-methyl-4-aminophenyl)-methan, |
| BIDM | : Bis-(3,5-diisopropyl-4-aminophenyl)-methan, |
| mDDS | : 3,3'-Diaminodiphenylsulfon, |
| pDDS | : 4,4'-Diaminodiphenylsulfon, |
| Diamingemisch | : Technisches Produkt bestehend aus 4,4'-Diaminodiphenylmethan, 3-Ethyl-4,4'-diaminodiphenylmethan und aus 3,3'-Diethyl-4,4'-diaminodiphenylmethan, |
| PA-PAS | : Polyamid-Polyamidsäure. |

Tabelle III: PA-PI-Blockcopolymere C

| PI - Block: Tetracarbonsäure-dianhydrid (Mol) | PI - Block: Diamin (Mol) | PA - Block: Dicarbonsäure-dichlorid (Mol) | PA - Block: Diamin (Mol) | $\eta_{inh}$ [dl/g] PA-PAS | $\eta_{inh}$ [dl/g] PA-PI | Löslichkeit in NMP [%] |
|---|---|---|---|---|---|---|
| BTDA 0,2970 | Diamingemisch 0,2447 | IPC 0,4455 | Diamingemisch 0,4957 | 0,45 | 0,49 | > 25 |
| BTDA 0,2815 | Diamingemisch 0,2470 | IPC 0,2177 | Diamingemisch 0,2470 | 0,35 | 0,41 | > 25 |
| BTDA 0,2002 | Diamingemisch 0,3566 | IPC 0,0643 | Diamingemisch 0,1585 | 0,33 | 0,49 | > 25 |
| BTDA 0,1551 | pDDS 0,1292 | IPC 0,2326 | Diamingemisch 0,1292; pDDS 0,1292 | 0,33 | 0,28 | > 25 |
| BTDA 0,1500 | mDDS 0,0417; pDDS 0,0417; Diamingemisch 0,0417 | IPC 0,2275 | Diamingemisch 0,0833; mDDS 0,0833; pDDS 0,0833 | 0,52 | 0,52 | > 25 |
| BTDA 0,1500 | mDDS 0,0417; pDDS 0,0417; BADM 0,0417 | IPC 0,2275 | BADM 0,0833; mDDS 0,0833; pDDS 0,0833 | 0,38 | 0,38 | > 25 |
| BTDA 0,1500 | mDDS 0,0417; pDDS 0,0417; BIDM 0,0417 | IPC 0,2275 | BIDM 0,0833; mDDS 0,0833; pDDS 0,0833 | 0,36 | 0,36 | > 25 |
| BPDA 0,1500 | Diamingemisch 0,1250 | IPC 0,2275 | Diamingemisch 0,2500 | 0,41 | 0,54 | > 20 |
| BPDA 0,1500 | pDDS 0,0625; Diamingemisch 0,0625 | IPC 0,2275 | pDDS 0,2500 | 0,85 | 0,67 | > 25 |
| BTDA 0,1250 | BADM 0,0938 | IPC 0,0938 | Diamingemisch 0,1250 | 0,56 | 0,54 | > 25 |
| BTDA 0,2500 | mDDS 0,0695; BEMA 0,0695; pDDS 0,0695 | IPC 0,3790 | mDDS 0,1389; BEMA 0,1389; pDDS 0,1389 | 0,48 | 0,40 | > 25 |
| BTDA 0,2500 | BEMA 0,1875 | IPC 0,1879 | BEMA 0,2500 | 0,49 | 0,51 | > 25 |
| TMAC 0,2500 | Diamingemisch 0,2920 | IPC 0,1690 | Diamingemisch 0,1250 | 0,67 | 0,59 | > 25 |
| BPDA 0,2500 | Diamingemisch 0,1875 | TMAC 0,1895 | Diamingemisch 0,2500 | 1,45 | 0,80 | > 25 |

Weitere geeignete, in polaren aprotischen Lösungsmitteln lösliche PA-PI-Blockcopolymere vom Typ D mit einem durchschnittlichen Molekulargewicht $\overline{M}_n$ von 1'000 bis 50'000, vorzugsweise 5'000 bis 40'000, enthalten die Kombination von Blöcken der Formeln IVa mit Vb und/oder Vc oder der Formeln IVb mit Va und/oder Vc oder der Formeln IVc mit Va und/oder Vb, mit der anderen Massgabe, dass 25-100 Mol % aller Reste $R_2$, $R_4$ und $R_6$, bezogen auf die Gesamtmenge dieser Reste, die Formel

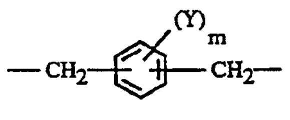

und/oder

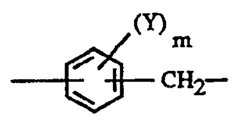

aufweisen, worin Y ein $C_1$-$C_8$-Alkyl oder Halogen bedeutet und m für eine Zahl von 0 bis 4 steht.

Der Alkylsubstituent Y in den oben angegebenen Formeln kann verzweigt oder bevorzugt geradkettig sein. Bevorzugt wird geradkettiges $C_1$-$C_6$Alkyl. Beispiele dafür sind Methyl, Ethyl, n-Propyl, n-Butyl, n-Pentyl und n-Hexyl. Besonders bevorzugt wird Methyl.

Y als Halogen ist vorzugsweise Chlor oder Brom, und m steht vorzugsweise für Null oder die Zahl 1.

Das Verhältnis von Polyamidblöcken zu Polyimidblöcken oder zu Polyamidimidblöcken in den erfindungsgemäss zu verwendenden Blockcopolymeren D wird im allgemeinen durch die gewünschte Löslichkeit dieser Copolymeren in polaren, aprotischen Lösungsmitteln bestimmt. Die jeweiligen Anteile dieser Blöcke und der Gehalt an Xylylendiamineinheiten und/oder an Aminobenzylamineinheiten werden so gewählt, dass das Blockcopolymere in polaren, aprotischen Lösungsmitteln löslich ist.

Das bevorzugte Verhältnis von Amidgruppen zu Imidgruppen in den zu verwendenden PA-PI-Blockcopolymeren D beträgt 4:1 bis 1:4.

Die mittleren Molekulargewichte $\overline{M}_n$ der Polyamidblöcke IVa oder Va oder der Polyimidblöcke IVb oder Vb oder der Polyamidimidblöcke IVc oder Vc in den PA-PI-Blockcopolymeren D betragen im allgemeinen 300 bis 20'000, vorzugsweise 500 bis 10'000.

Neben den oben erwähnten Kombinationen von zwei Blöcken können die erfindungsgemäss zu verwendenden PA-PI-Blockcopolymeren D auch Dreiblockkombinationen der Formeln IVa, IVb und Vc oder IVa, IVc und Vb oder IVb, IVc und Va enthalten.

Besonders bevorzugt sind PA-PI-Blockcopolymere D die im wesentlichen aus den wiederkehrenden Struktureinheiten der Formeln IVa und IVb oder IVb und Va bestehen.

Ganz besonders bevorzugte PA-PI-Blockcopolymere dieses Typs enthalten die Xylylendiamineinheiten oder die Aminobenzylamineinheiten oder eine Kombination von Xylylendiamineinheiten und Aminobenzylamineinheiten nur in den Polyimidblöcken IXb oder Xb.

Die Herstellung dieser erfindungsgemäss zu verwendenden PA-PI-Blockcopolymeren D kann ebenfalls in an sich bekannter Weise durch Umsetzung vorgeformter Polyamid- und Polyamidsäureblöcke und anschliessende Cyclisierung der Polyamid-Polyamidsäure erfolgen.

Beispiele für mögliche Kombinationen von Polyamid- mit Polyimidblöcken zu PA-PI-Blockcopolymeren D sind in folgender Tabelle IV angegeben, in der folgende Abkürzungen verwendet werden:

BTDA : 3,3',4,4'-Benzophenontetracarbonsäuredianhydrid,
BPDA : 3,3',4,4'-Biphenyltetracarbonsäuredianhydrid,
IPC : Isophthalsäuredichlorid,
TMAC : Trimellitsäureanhydridchlorid,
mXDA : m-Xylylendiamin,
pXDA : p-Xylylendiamin,
ABA : Aminobenzylamin (Gemisch von m- und p-Isomeren),
mPDA : m-Phenylendiamin
mDDS : 3,3'-Diaminodiphenylsulfon,
pDDS : 4,4'-Diaminodiphenylsulfon,
PA-PAS : Polyamid-Polyamidsäure.

Tabelle IV: PA-PI-Blockcopolymere D

| PI - Block<br>Tetracarbonsäure-dianhydrid (Mol) | PI - Block<br>Diamin (Mol) | PA - Block<br>Dicarbonsäure-dichlorid (Mol) | PA - Block<br>Diamin (Mol) | $\eta_{inh}$ [dl/g]<br>PA-PAS | $\eta_{inh}$ [dl/g]<br>PA-PI | Löslichkeit in NMP (%) nach Trocknung bei 200°C |
|---|---|---|---|---|---|---|
| BPDA 0,1500 | mXDA 0,0625 pDDS 0,0625 | IPC 0,2275 | pDDS 0,2500 | 0,64 | 0,74 | > 25 |
| BTDA 0,1500 | mXDA 0,0625 pDDS 0,0625 | IPC 0,2275 | pDDS 0,2500 | 0,59 | 0,67 | > 25 |
| BTDA 0,1500 | mXDA 0,0625 mDDS 0,0625 | IPC 0,2275 | mDDS 0,2500 | 0,33 | 0,59 | > 25 |
| BTDA 0,1500 | mXDA 0,0625 mDDS 0,0313 pDDS 0,0313 | IPC 0,2275 | mDDS 0,1250 pDDS 0,1250 | 0,48 | 0,54 | > 25 |
| BTDA 0,1500 | mXDA 0,0416 mDDS 0,0416 pDDS 0,0416 | IPC 0,2275 | mDDS 0,0833 pDDS 0,0833 mPDA 0,0833 | 0,40 | 0,40 | > 25 |
| BTDA 0,0919 | mXDA 0,0395 pDDS 0,0397 | IPC 0,1608 | mXDA 0,0858 mPDA 0,0854 | 0,40 | 0,31 | > 25 |
| TMAC 0,1066 | mXDA 0,1247 | IPC 0,2352 | mPDA 0,2136 | 0,23 | 0,25 | > 25 |
| BTDA 0,1250 | pXDA 0,0521 pDDS 0,0521 | IPC 0,1900 | pDDS 0,2084 | 0,45 | 0,43 | > 25 |
| BTDA 0,1250 | ABA 0,0521 pDDS 0,0521 | IPC 0,1900 | pDDS 0,2084 | 0,45 | 0,35 | > 25 |
| BTDA 0,1250 | pDDS 0,1042 | IPC 0,1900 | ABA 0,1042 pDDS 0,1042 | 0,36 | 0,28 | > 25 |
| BTDA 0,1250 | pDDS 0,0521 ABA 0,0521 | IPC 0,1900 | ABA 0,1042 pDDS 0,1042 | 0,35 | 0,31 | > 25 |
| BTDA 0,1250<br>TMAC 0,1250 | pDDS 0,1460 mXDA 0,1460 | IPC 0,3610 | pDDS 0,3210 | 0,52 | 0,46 | > 25 |

Die Herstellung der erfindungsgemäss zu verwendenden Blockcopolymeren erfolgt in an sich bekannter Weise und kann beispielsweise nach einer der in der DE-A-2,342,464 beschriebenen Arbeitsweise durch Umsetzung vorgeformter Polyamid- und Polyamidsäure- und/oder Polyamidamidsäureblöcke und anschliessende Cyclisierung der Polyamid-Polyamidsäuren erfolgen.

Gemäss einer weiteren Herstellungsmethode können Polyamidsäureblöcke mit geeigneten Endgruppen, vorzugsweise Anhydridgruppen, mit Diaminen oder Dicarbonsäurederivaten, beispielsweise Dicarbonsäurechloriden und/oder Tricarbonsäureanhydrid-chloriden, umgesetzt und die so erhaltenen Polyamidsäuren cyclisiert werden.

Die erfindungsgemäss zu verwendenden Blockcopolymeren können auch dadurch hergestellt werden, indem man in an sich bekannter Weise zuerst einen Polyamid- und/oder Polyamidamidsäureblock aufbaut und diesen anschliessend mit einem geeigneten Tetracarbonsäurederivat und einem Diamin bzw. mit einem geeigneten Dicarbonsäuredichlorid und einem Diamin zu einem Polyamid-Polyamidamidsäure-Blockcopolymer umsetzt und dieses anschliessend cyclisiert. Ein solches Verfahren ist beispielsweise in der DE-A-2,342,454 beschrieben.

Beispielsweise kann ein PA-PI-Blockcopolymer vom Typ A hergestellt werden, indem man Polyamide der Formel VII

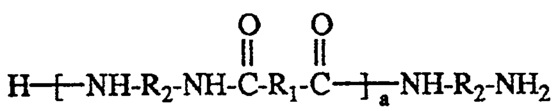

(VII)

mit Polyamidsäuredianhydriden der Formel VIII

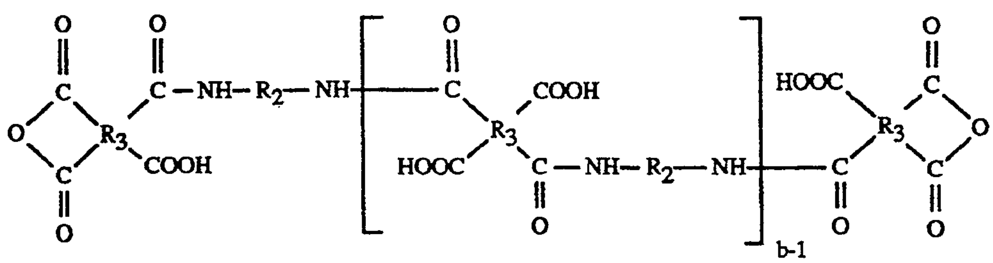

(VIII)

oder Polyamide der Formel IX

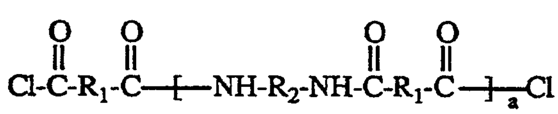

(IX)

mit Polyamidsäuren der Formel X

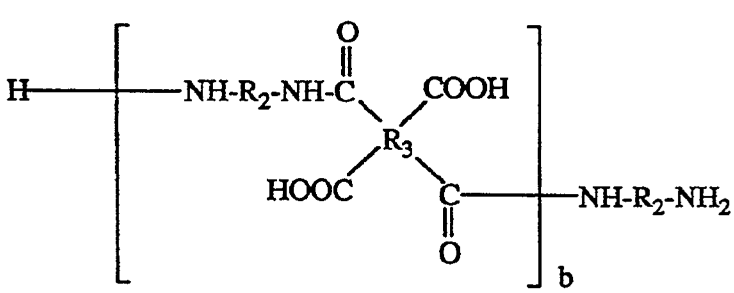

(X)

umsetzt, oder indem man Polyamidsäuren der Formel VIII oder X mit Dicarbonsäuredichloriden der Formel XI

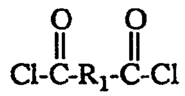

(XI)

und Diaminen der Formel XII

$H_2N\text{-}R_2\text{-}NH_2$ (XII)

umsetzt und die so erhaltenen Polyamid-Polyamidsäure-Copolymeren anschliessend cyclisiert, und wobei in den Formeln VII bis XII $R_1$, $R_2$ und $R_3$ die gleiche Bedeutung wie in Formeln III und IV haben und a und b unabhängig voneinander eine ganze Zahl von mindestens 2 bedeuten.

Die Verbindungen der Formeln VII bis XII sind bekannt. Die Herstellung der Polyamidsäuren der Formeln VIII und X ist ebenfalls in der DE-A 2,342,464 beschrieben und erfolgt z.B. durch die Umsetzung von Tetracarbonsäuredianhydriden der Formel XIII

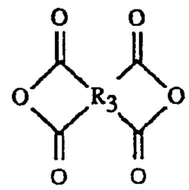

(XIII),

worin $R_3$ die angegebene Bedeutung hat, mit einem Unterschuss bzw. Ueberschuss eines Diamins der Formel XII. Dabei ist es trivial und dem Fachmann geläufig, wie er durch geeignete Reaktionsbedingung, z.B. durch geeignete Wahl der Molverhältnisse der Reaktionspartner, die mittleren oben definierten Molekulargewichte (und damit a und b) der einzelnen Blöcke einstellen kann. Die Polykondensation der Di- oder Tetracarbonsäurederivate der Formeln VIII, IX bzw. XI mit den Diaminen der Formeln VII bzw. XII kann auf an sich bekannte Weise vorgenommen werden, vorzugsweise in einem wasserfreien organischen Lösungsmittel und unter Feuchtigkeitsausschluss, z.B. unter Stickstoff, bei Temperaturen zwischen etwa -20°C und +50°C, insbesondere etwa -15°C bis +10°C.Geeignete organische Lösungsmittel sind polare aprotische Lösungsmittel, wie N,N-Dimethylacetamid, N,N-Diethylacetamid, N,N-Dimethylformamid, N,N-Dimethylmethoxyacetamid, 2-Methyl-2-pyrrolidon, N-Acetyl-2-pyrrolidon, N-Methyl-ε-caprolactam, N,N,N',N'-Tetramethylharnstoff, Tetrahydrothiophendioxid (Sulfolan) und Dimethylsulfoxid.

Die Reaktion kann auch in Gemischen solcher Lösungsmittel durchgeführt werden. Andererseits ist es auch möglich, diese bevorzugten Lösungsmittelsysteme mit anderen organischen aprotischen Lösungsmitteln, wie aromatischen, cycloaliphatischen oder aliphatischen Kohlenwasserstoffen, beispieleweise Toluol, Xylolen, Cyclohexan, Pentan, Hexan, Methylenchlorid, Tetrahydrofuran und Cyclohexanon, zu verdünnen.

Die Polyamidblöcke können auch mittels Grenzflächen-Polykondensation hergestellt werden.

Die Blockcopolymeren der Typen B, C und D können unter Verwendung der entsprechenden Ausgangsverbindungen nach den gleichen oben angegebenen Verfahren hergestellt werden.

Eine weitere Herstellungsmethode für die Blockcopolymeren vom Typ B, C und D umfasst die Umsetzung von Polyamidsäuren der Formel VIII und/oder XIV

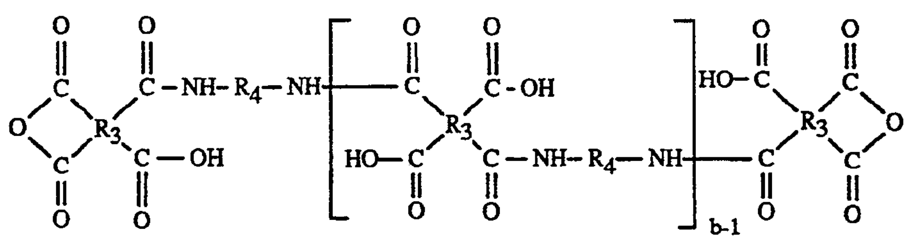

(VIII)

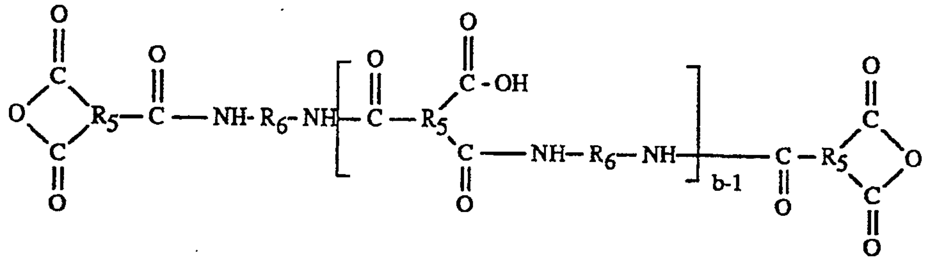 (XIV)

mit Diaminen der Formel XII

$$H_2N\text{-}R_2\text{-}NH_2 \qquad (XII)$$

und mit Dicarbonsäurechloriden der Formel XI

$$Cl\text{-}OC\text{-}R_1\text{-}CO\text{-}Cl \qquad (XI)$$

und die anschliessende Cyclisierung der so erhaltenen Polyamid-Polyamidsäure Blockcopolymeren. In den Formeln VIII, XIV, XII und XI haben die Symbole $R_1$, $R_2$, $R_3$, $R_4$, $R_5$ und $R_6$ die oben angegebene Bedeutung und b steht für eine ganze Zahl von mindestens 2.

Die Herstellung der Polyamidsäure der Formel XIV ist ebenfalls an sich bekannt und erfolgt beispielsweise durch die Umsetzung von Tricarbonsäureanhydriden der Formel XV oder einem entsprechenden Tricarbonsäureanhydridchlorid

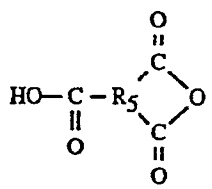 (XV),

worin $R_5$ die oben angegebene Bedeutung hat, mit einem Unterschuss eines Diamins der Formel XII.

Die Ausgangsprodukte der Formel XV sind an sich bekannt und teilweise im Handel erhältlich.

Die Herstellung von DMCD-Dianhydrid

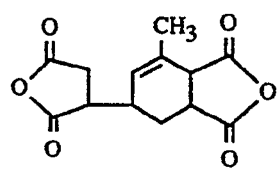

ist aus der EP-A-9,645 bekannt und kann durch Umsetzung von 3-Methyl-4-cyclohexen- 1,2-dicarbonsäureanhydrid mit Maleinsäureanhydrid erfolgen. Es ist auch im Handel erhältlich.

Durch Wahl der geeigneten Reaktionsbedingungen, wie z.B. durch geeignete Wahl der Molverhältnisse der Reaktionspartner, lassen sich die gewünschten mittleren Molekulargewichte der einzelnen Blöcke einstellen. Diese Auswahl ist dem Fachmann an sich bekannt.

Die Polykondensation der Di-, Tri- oder Tetracarbonsäurederivate der Formeln VIII, XIV, XI und XV mit den Diaminen der Formel XII kann auf an sich bekannte Weise vorgenommen werden, vorzugsweise in einem wasserfreien organischen Lösungsmittel und unter Feuchtigkeitsausschluss, z.B. unter Stickstoff bei Temperaturen zwischen -20°C und +50°C, insbesondere etwa -15°C bis +10°C.

Gewünschtenfalls kann auch ein Gemisch von verschiedenen PA-PI-Blockcopolymeren eingesetzt werden.

Die erfindungsgemässen Gemische zeichnen sich durch eine gute Verarbeitbarkeit aus und können beispielsweise als Matrixharze, Lacke, Klebstoffe, Ueberzugsmassen, Press- und Sinterpulver zur Herstellung von industriellen Erzeugnissen aller Art, wie beispielsweise faserverstärkten Verbundstoffen, Laminaten, Verklebungen, Schaumstoffe, Ueberzügen, Beschichtungen, Filmen, Folien oder Presskörpern verwendet werden.

Vor der Verarbeitung der beispielsweise als Pulver oder insbesondere als Lösung vorliegenden Gemische können übliche Zusatzstoffe, wie beispielsweise Füllstoffe, Pigmente, Stabilisatoren oder Verstärkungsmittel,

wie Kohlenstoff-, Bor-, Metall- oder Glasfasern, zugegeben werden. Insbesondere kann der Zusatz von sogenannten Verlaufsmitteln, beispielsweise das Produkt BYK®S 706 der Firma BYK-Chemie, Wesel vorteilhaft sein. Der Zusatz an Verlaufsmitteln stellt eine bevorzugte Ausführungsform der Erfindung dar.

Aufgrund einer guten Löslichkeit der erfindungsgemässen Gemische in polaren aprotischen Lösungsmitteln, wobei diese mit anderen gebräuchlichen Lösungsmitteln, wie halogenierten Kohlenwasserstoffen, verdünnt werden können, lassen sich die Gemische vorteilhaft aus einer Lösung heraus zu Filmen verarbeiten oder zur Herstellung von Beschichtungen auf Substrate aller Art verwenden. Bevorzugte Lösungsmittel sind N-Methylpyrrolidon, Dimethylsulfoxid und γ-Butyrolacton.

Als geeignete Substrate seinen erwähnt: Metalle oder Legierungen, wie Kupfer, Messing, Aluminium, Eisen oder Stahl; Asbest- oder Glasfasermaterialien; Polymere, wie Cellulosematerialien (Celluloseester oder -ether, Papier), Polyester, Polyamide, Polyimide oder Polyurethane.

Nach der Applikation und dem Trocknen der Beschichtung, beispielsweise 30 Minuten bei 180°C, wird diese durch kurzes Erwärmen, beispielsweise auf eine Temperatur zwischen 220-280°C, lösungsmittelbeständig. Die lösungsmittelstabilen Beschichtungen zeichnen sich durch eine gute Haftung, vorzugsweise auf Metallen, und durch eine sehr gute Oberflächenbeschaffenheit aus. Mit den erfindungsgemässen Gemischen lässen sich somit Beschichtungen herstellen, bei denen die guten mechanischen Eigenschaften der PA-PI-Blockcopolymeren, wie hohe Flexibilität, erhalten bleiben, keine Versprödung durch den Zusatz von Epoxidharzen feststellbar ist, eine sehr gute Haftfestigkeit und eine hohe Lösungsmittelbeständigkeit erzielt wird.

Es wurde ferner gefunden, dass mit den erfindungsgemässen Gemischen beschichtete Metallfolien ohne Verwendung zusätzlicher Verklebungshilfen, wie beispielsweise Acrylatkleber, direkt zu mehrschichtigen Laminaten verklebt werden können.

Gegenstand vorliegender Erfindung sind somit auch Laminate, vorzugsweise Metall-laminate und insbesondere Kupferlaminate, in denen die Verklebung aus dem erfindungsgemässen Gemisch, enthaltend ein Epoxidharz (a) und ein lösliches PA-PI-Block-copolymer (b), besteht. Die Herstellung der Verklebung erfolgt dabei unter Druck und bei einer Temperatur, die ein zumindest geringes Fliessen des PA-PI-Blockcopolymer/Epoxidharz-Gemisches erlaubt, beispielsweise im Temperaturbereich von 180 bis 320°C, bevorzugt von 200 bis 300°C.

Die Temperatur richtet sich dabei nach der Glasübergangstemperatur des PA-PI-Blockcopolymeren, dem Gehalt an Epoxidharzen und der gewünschten Press- und Druckzeit. So wird man bei einem PA-PI-Blockcopolymeren mit niedriger Glasübergangstemperatur und hohem Epoxidharzanteil bevorzugt eine niedrige Verarbeitungstemperatur wählen. Im Fall eines PA-PI-Blockcopolymeren mit hoher Glasübergangstemperatur und niedrigem Epoxidharzanteil wird die Presstemperatur bevorzugt im höheren Bereich liegen.

Bevorzugte Anwendung solcher Laminate, die sehr flexibel sind und mehrmals ohne Bruch gefaltet werden können, erfolgt in der Elektronikindustrie zur Herstellung von Schaltungen.

In den folgenden Beispielen werden folgende Epoxidharze eingesetzt.

<u>Epoxidharz I:</u> Bisphenol A-diglycidylether mit einem Epoxidgehalt von 5,6 bis 5,7 Aequivalenten/kg und einer Viskosität von 4500 bis 5900 mPa·s bei 25°C.

<u>Epoxidharz II:</u> N,N,N',N'-Tetraglycidyl-4,4'-diaminodiphenylmethan mit einem Epoxidgehalt von 7,5 bis 8,5 Aequivalenten/kg und einer Viskosität von 10000 bis 17000 mPa·s bei 50°C.

<u>Epoxidharz III:</u> N,N,O-Triglycidyl-p-aminophenol mit einem Epoxidgehalt von 9,35 bis 10,53 Aequivalenten/kg und einer Viskosität von 550 bis 850 mPa·s bei 25°C.

<u>Epoxidharz IV:</u> Bisphenol F-diglycidylether mit einem Epoxidgehalt von 5,55 bis 5,95 Aequivalenten/kg und einer Viskosität von 3000 bis 100000 mPa·s bei 25°C.

<u>Epoxidharz V:</u> Triglycidylisocyanurat mit einem Epoxidgehalt von 9,3 bis 10,0 Aequivalenten/kg und einem Schmelzbereich von 86 bis 96°C.

<u>Epoxidharz VI:</u> Polyphenol A-tetraglycidylether (Tetra-(p-glycidyloxyphenyl)-ethan) mit einem Epoxidgehalt von 5,1-5,4 Aequivalenten/kg und einem Erweichungspunkt nach Kofler von 65-85°C.

<u>Epoxidharz VII:</u> Festes Bisphenol A-diglycidyletherharz mit einem Epoxidgehalt von 2,15-2,22 Aequivalenten/kg und einem Erweichungspunkt von 50°C nach Kofler.

<u>Epoxidharz VIII:</u> o,o'-Diallylbisphenol A-diglycidylether mit einem Epoxidgehalt von 4,6 Aequivalenten/kg.

<u>Epoxidharz IX:</u> N,N,N',N'-Tetraglycidyl-4,4'-diaminodiphenylmethan mit einem Epoxidgehalt von 8,7 bis 9,1 Aequivalenten/kg und einer Viskosität von 4000 bis 6000 mPa·s bei 50°C.

<u>Epoxidharz X</u> Bisphenol-S-diglycidylether mit einem Epoxidgehalt von 5,3 Aequivalenten/kg.

<u>Epoxidharz XI:</u> Phenolnovolakepoxidharz mit einem Epoxidgehalt von 5,6 bis 5,8 Aequivalenten/kg und einer Viskosität von 1100 bis 1700 mPa·s bei 50°C.

<u>Epoxidharz XII:</u> 3,4-Epoxycyclohexylmethyl-3,4-epoxycyclohexancarboxylat mit einem Epoxidgehalt von 7,0 bis 7,5 Aequivalenten/kg und einer Viskosität von 450 bis 520 mPa·s bei 25°C.

Für die nachfolgenden Beispiele werden PA-PI-Blockcopolymere nach an sich bekannten Verfahren in den

folgenden Zusammensetzungen hergestellt:

PA-PI-Blockcopolymer A :

Gemäss Beispiel 1 der EP-A-0 324 315 wird ein Polyimid-Block synthetisiert aus 120,84 g (0,375 Mol) 3,3',4,4'-Benzophenontetracarbonsäuredianhydrid, 38,88 g (0,156 Mol) 4,4'-Diaminodiphenylsulfon und 38,88 g (0,156 Mol) 3,3'-Diaminodiphenylsulfon und ein Polyamid-Block synthetisiert aus 44,48 g 0,2235 Mol) Isophthalsäuredichlorid, 31,1 g (0,125 Mol) 4,4'-Diaminodiphenylsulfon und 31,1 g (0,125 Mol) 3,3'-Diaminodiphenylsulfon. Die inh. Viskosität (0,5 Gew.-% Polymeres in N-Methylpyrrolidon (NMP) bei 25°C) beträgt 0,40 dl/g.

PA-PI-Blockcopolymer B :

Gemäss Beispiel 1 der EP-A-0 324 315 wird ein PolyimidBlock synthetisiert aus 100,7 g (0,3125 Mol) 3,3',4,4'-Benzophenontetracarbonsäuredianhydrid, 32,4 g (0,1303 Mol) 4,4'-Diaminodiphenylsulfon und 32,4 g (0,1303 Mol) 3,3'-Diaminodiphenylsulfon und ein Polyamid-Block synthetisiert aus 96,12 g 0,4693 Mol) Isophthalsäuredichlorid, 64,80 g (0,2606 Mol) 4,4'-Diaminodiphenylsulfon und 64,80 g (0,2606 Mol) 3,3'-Diaminodiphenylsulfon. Die inh. Viskosität (0,5 Gew.-% Polymeres in NMP bei 25°C) beträgt 0,57 dl/g.

PA-PI-Blockcopolymer C :

Polyamidsäureblock: In einem Doppelmantelreaktionsgefäss mit Schutzgasanschluss, Innenthermometer, Tropftrichter und Rührer werden unter Stickstoff 90,13 g (0,3125 Mol) 3,3',4,4'-Benzophenontetracarbonsäuredianhydrid und 500 g NMP eingewogen. Das Reaktionsgefäss wird dreimal evakuiert und mit Stickstoff begast. Nach Abkühlen auf -7°C ergibt sich eine Suspension. Über den Tropftrichter wird bei einer Temperatur zwischen -7 und -4°C im Verlauf von 80 Minuten eine Lösung von 30,57 g (0,1303 Mol) 4,4'-Diaminodiphenylsulfon und von 16,52 g (0,1303 Mol) m-Xylylendiamin in 156 g NMP zugegeben. Danach lässt man die Reaktionsmischung auf Raumtemperatur kommen und rührt 2 Stunden nach.

Polyamid-Polyamidsäure-Blockcopolymeres: Die klare Reaktionsmischung wird erneut abgekühlt (-7°C). Über den Tropftrichter werden sodann 125,21 g (0,5210 Mol) 4,4'-Diaminodiphenylsulfon in 300 g NMP im Verlauf von 150 Minuten zugetropft. Im folgenden werden 90,68 g (0,4693 Mol) Isophthalsäuredichlorid portionsweise zugegeben, so dass die Innentemperatur 0°C nicht übersteigt. Man benötigt etwa 150 Minuten, wobei die Lösung in zunehmendem Masse viskos wird. Schliesslich wird die Polymerlösung bei Raumtemperatur 50 Minuten gerührt. Man setzt weitere 0,51 g (0,0025 Mol) Isophthalsäuredichlorid zu und rührt 3 Stunden zur Vervollständigung der Polykondensation.

Danach gibt man über einen Tropftrichter im Verlauf von 20 Minuten 34,00 g (0,4725 Mol) Butylenoxid zu (Innentemperatur 20-25°C). Man erhält auf diese Weise eine Lösung eines Polyamid-Polyamidsäure-Blockcopolymeren mit einer inh. Viskosität von 0,64 dl/g (0,5 Gew.-% an Feststoff in NMP/25°C).

Cyclisierung: Die nun vorliegende Polyamid-Polyamidsäure Blockcopolymeren-Lösung wird nun der chemischen Cyclisierung zum Polyamid-Polyimid-Blockcopolymeren unterzogen. Dazu erfolgt über einen Tropftrichter zunächst die Zugabe von 79,69 g (0,7875 Mol) Triethylamin innerhalb von 45 Minuten und dann von 80,40 g (0,7875 Mol) Acetanhydrid innerhalb von 40 Minuten bei 20-25°C. Man lässt nun weitere 6 Stunden bei Raumtemperatur rühren. Ein Teil der oben beschriebenen Lösung wird mit der gleichen Menge NMP verdünnt, in der 10-fachen Menge Isopropanol ausgefällt und im Vakuumtrockenschrank getrocknet, wobei die Temperatur innerhalb von 72 Stunden auf 240°C erhöht wird. Die inh. Viskosität (0,5 Gew.-% Feststoff, NMP, 25°C) eines so hergestellten Polyamid-Polyimid-Blockcopolymeren beträgt 0,69 dl/g.

PA-PI-Blockcopolymer D :

Gemäss Beispiel 1 der EP-A-0 381 620 wird ein PolyimidBlock synthetisiert aus 120,84 g (0,375 Mol) 3,3',4,4'-Benzophenontetracarbonsäuredianhydrid und 66,12 g eines Diamingemisches Z und ein Polyamid-Block synthetisiert aus 57,76 g (0,238 Mol) Isophthalsäuredichlorid und 87,0 g eines Diamingemisches Z. Die inh. Viskosität (0,5 Gew.-% Polymeres in NMP bei 25°C) beträgt 0,52 dl/g.

Das Diamingemisch Z ist ein technisches Gemisch bestehend aus 4,4'-Diamin-diphenylmethan, 3-Ethyl-4,4'-diaminodiphenylmethan und 3,3'-Diethyl-4,4'-diaminodiphenylmethan wobei der Anteil an substituiertem Diaminodiphenylmethan grösser als 80 Gew.-% ist.

PA-PI-Blockcopolymer E:

Gemäss Beispiel 1 der EP-A-0 381 620 wird ein Polyimidblock synthetisiert aus 120,84 g (0,375 Mol) 3,3',4,4'-Benzophenontetracarbonsäuredianhydrid und 66,12 g des Diamingemisches Z und ein Polyamidblock synthetisiert aus 56,46 g (0,278 Mol) Isophthalsäuredichlorid und 87,00 g des Diamingemisches Z. Die inh. Viskosität (0,5 Gew.-% Polymers in NMP bei 25°C) beträgt 0,48 dl/g.

PA-PI-Blockcopolymer F:

Gemäss Beispiel 1 der EP-A-0 381 620 wird ein Polyimidblock synthetisiert aus 120,84 g (0,375 Mol) 3,3',4,4'-Benzophenontetracarbonsäuredianhydrid und 71,48 g (0,281 Mol) 3,3'-Diethyl-4,4'-diaminodiphenylmethan und ein Polyamidblock synthetisiert aus 57,65 g (0,284 Mol) Isophthalsäuredichlorid und 95,65 g (0,375 Mol) 3,3'-Diethyl-4,4'-diaminodiphenylmethan. Die inh. Viskosität (0,5 Gew.-% Polymeres in NMP bei 25°C) beträgt 0,61 dl/g.

PA-PI-Blockcopolymer G:

Gemäss Beispiel 1 der EP-A-0 381 621 wird ein Polyimidblock synthetisiert aus 100,70 g (0,3125 Mol) 3,3',4,4'-Benzophenontetracarbonsäuredianhydrid, 7,10 g (0,0521 Mol) m-Xylylendiamin, 25,92 g (0,1042 Mol) 3,3'-Diaminodiphenylsulfon und 25,92 g(0,1042 Mol) 4,4'-Diaminodiphenylsulfon und ein Polyamidblock synthetisiert aus 32,02 g (0,1579 Mol) Isophthalsäuredichlorid, 25,92 g (0,1042 Mol) 3,3'-Diaminodiphenylsulfon und 25,92 g (0,1042 Mol) 4,4'-Diaminodiphenylsulfon. Die inh. Viskosität (0,5 Gew.-% Polymeres in NMP bei 25°C) beträgt 0,66 dl/g.

PA-PI-Blockcopolymer H :

Gemäss Beispiel 1 der EP-A-0 381 620 wird ein Polyimidblock synthetisiert aus 120,84 g (0,375 Mol) 3,3',4,4'-Benzophenontetracarbonsäuredianhydrid und 71,48 g (0,281 Mol) 3,3'-Diethyl-4,4'-diaminodiphenylmethan und ein Polyamidblock synthetisiert aus 57,65 g (0,284 Mol) Isophthalsäuredichlorid und 95,61 g (0,375 Mol) 3,3'-Diethyl-4,4'-diaminodiphenylmethan. Die inh. Viskosität (0,5 Gew.-% Polymeres in NMP bei 25°C) beträgt 0,60 dl/g.

PA-PI-Blockcopolymer I:

Gemäss Beispiel 1 der EP-A-0 381 620 wird ein Polyimidblock synthetisiert aus 73,52 g (0,25 Mol) 3,3',4,4'-Biphenyltetracarbonsäuredianhydrid und 43,50 g des Diamingemisches Z und ein Polyamidblock synthetisiert aus 39,89 g (0,1895 Mol) Trimellithsäureanhydridchlorid und 58,00 g des Diamingemisches Z. Die inh. Viskosität (0,5 Gew.-% Polymeres in NMP bei 25°C) beträgt 0,80 dl/g.

PA-PI-Blockcopolymer J:

Gemäss Beispiel 1 der EP-A-0 381 620 wird ein Polyimidblock synthetisiert aus 73,64 g (0,3375 Mol) Pyromellitsäuredianhydrid, 33,11 g (0,1125 Mol) 3,3',4,4'-Biphenyltetracarbonsäuredianhydrid und 97,19 g des Diamingemisches Z und ein Polyamidblock synthetisiert aus 15,2 g (0,0946 Mol) Isophthalsäuredichlorid und 28,32 g des Diamingemisches Z. Die inh. Viskosität (0,5 Gew.-% Polymeres in NMP bei 25°C) beträgt 0,63 dl/g.

PA-PI-Blockcopolymer K:

Gemäss Beispiel 1 der EP-A-0 381 620 wird ein Polyimidblock synthetisiert aus 80,56 g (0,25 Mol) 3,3',4,4'-Benzophenontetracarbonsäuredianhydrid, 21,57 g (0,0695 Mol) 3,3',5,5'-Tetraethyl-4,4'-diaminodiphenylmethan, 17,28 g (0,0695 Mol) 3,3'-Diaminodiphenylsulfon und 17,28 g (0,0695 Mol) 4,4'-Diaminodiphenylsulfon und ein Polyamidblock synthetisiert aus 76,90 g (0,379 Mol) Isophthalsäuredichlorid, 43,04 g(0,1389 Mol) 3,3',5,5'-Tetramethyl-4,4'-diaminodiphenylmethan, 34,56 g (0,1389 Mol) 4,4'-Diaminodiphenylsulfon und 34,56 g (0,1389 Mol) 3,3'-Diaminodiphenylsulfon. Die inh. Viskosität (0,5 Gew.-% Polymeres in NMP bei 25°C) beträgt 0,45 dl/g.

PA-PI-Blockcopolymer L:

Gemäss Beispiel 1 der EP-A-0 381 620 wird ein Polyimidblock synthetisiert aus 120,84 g (0,375 Mol) 3,3',4,4'-Benzophenontetracarbonsäuredianhydrid, 38,88 g (0,156 Mol) 4,4'-Diaminodiphenylsulfon und 38,88 g (0,156 Mol) 3,3'-Diaminodiphenylsulfon und ein Polyamidblock synthetisiert aus 38,56 g (0,1877 Mol) Isophthalsäuredichlorid, 31,10 g (0,125 Mol) 4,4'-Diaminodiphenylsulfon und 31,10 g (0,125 Mol) 3,3'-Diaminodiphenylsulfon. Die inh. Viskosität (0,5 Gew.-% Polymeres in NMP bei 25°C) beträgt 0,46 dl/g.

Beispiele 1 bis 65:

Herstellung und Eigenschaften von Zweischichtlaminaten aus PA-PI-Blockcopolymeren/Epoxidharz-Zusammensetzungen Das jeweilige PA-PI-Blockcopolymere wird in NMP gelöst und nach vollständiger Lösung wird das jeweilige Epoxidharz im angegebenen Verhältnis zugegeben, so dass eine 25 gew.-%ige Lösung in NMP resultiert. Diese Lösung wird mittels einer Lackhantel 200 µm dick auf eine 35 µm-dünne Kupferfolie aufgetragen und im Umluft-Lacktrockenschrank unter IR-Bestrahlung getrocknet (Bedingungen: Umluft-Temperatur: 180°C, 45 Minuten, IR-Lampe: Heraeus Modell MMS 1200). Ein Teil der beschichteten Folie wird in 1 cm breite Streifen zerschnitten und das "Flex-Life" des Laminates bestimmt ("Flex-Life" = Zahl der Faltungen bis zum Bruch des Laminates, bestimmt mittels Universal-Model 2 FDF Flex Ductility Tester mit Zuggewicht 224 g und 2 mm Dorn). An einem weiteren Teil des Laminates (etwa 8 x 8 cm) wird durch ein- und zweistündiges Eintauchen in NMP bei 20°C die Lösungsmittelstabilität bestimmt.

In nachfolgender Tabelle 1 werden die Eigenschaften der erfindungsgemässen Laminate angegeben.

Tabelle 1: Eigenschaften von flexiblen Laminaten auf der Basis von PA-PI-Block-copolymer/Epoxidharz-Zusammensetzungen

| Beispiel | PA-PI-Block copolymeres | Epoxidharz | Verhältnis PA-PI/Epoxidharz [Gew.-teile] | Flex-Life | Gewichtsänderung in % nach NMP-Lag. 1 h | 2 h | Glasübergangstemp. (DSC) [°C] |
|---|---|---|---|---|---|---|---|
| 1 | A | I | 97,5/2,5 | 391 | 0,8 | 0,3 | 275 |
| 2 | A | I | 95/5 | 350 | 1,6 | 1,9 | 271 |
| 3 | A | I | 92,5/7,5 | 406 | 0,8 | 1,8 | 266 |
| 4 | A | I | 90/10 | 380 | 1,0 | 1,7 | 260 |
| 5 | A | II | 97,5/2,5 | 378 | 1,0 | 0,2 | 274 |
| 6 | A | III | 97,5/2,5 | 433 | 0,5 | 3,8 | 272 |
| 7 | A | III | 95/5 | 378 | 1,4 | 1,4 | 278 |
| 8 | A | IV | 97,5/2,5 | 354 | 0,1 | 0,9 | 274 |
| 9 | A | IV | 95/5 | 367 | 1,1 | 1,1 | 277 |
| 10 | A | V | 97,5/2,5 | 407 | 0,7 | 1,4 | 278 |
| 11 | A | VI | 97,5/2,5 | 383 | 0,6 | 0,7 | 265 |
| 12 | A | VI | 95/5 | 447 | 1,2 | 1,5 | 259 |
| 13 | B | I | 97,5/2,5 | 419 | 0,0 | 2,0 | 271 |
| 14 | B | I | 92,5/7,5 | 385 | 0,8 | 2,8 | 273 |
| 15 | B | I | 90/10 | 385 | 2,1 | 5,6 | 256 |
| 16 | B | III | 97,5/2,5 | 368 | 1,6 | 3,7 | 275 |
| 17 | B | IV | 97,5/2,5 | 382 | 0,1 | -1,4 | 276 |
| 18 | C | I | 97,5/2,5 | 395 | -0,4 | 0 | 272 |
| 19 | C | I | 95/5 | 335 | 4,5 | 5,3 | 272 |

Tabelle 1 (Fortsetzung)

| Beispiel | PA-PI-Block copolymeres | Epoxidharz | Verhältnis PA-PI/Epoxidharz [Gew.-teile] | Flex-Life | Gewichtsänderung in % nach NMP-Lag. 1 h | 2 h | Glasübergangstemp. (DSC) [°C] |
|---|---|---|---|---|---|---|---|
| 20 | A | I | 85/15 | 414 | 1.0 | 2,8 | 251 |
| 21 | A | I | 80/20 | 399 | 4,6 | 1,2 | 242 |
| 22 | A | I | 70/30 | 418 | 3,1 | 2,6 | 225 |
| 23 | A | III | 90/10 | 367 | 1,4 | 2,0 | 254 |
| 24 | B | I | 80/20 | 403 | 3,0 | 3,0 | 238 |
| 25 | B | VI | 90/10 | 386 | 1,4 | 1,8 | 252 |
| 26 | B | VII | 95/5 | 378 | -0,4 | 5,8 | 256 |
| 27 | B | VII | 90/10 | 341 | 3,0 | 6,2 | 252 |
| 28 | B | VIII | 97,5/2,5 | 364 | 0,2 | -0,7 | 278 |
| 29 | B | VIII | 95/5 | 378 | 3,4 | 3,5 | 285 |
| 30 | B | VIII | 90/10 | 409 | 1,0 | 4,1 | 275 |
| 31 | C | I | 80/20 | 422 | 2,4 | 5,0 | 249 |
| 32 | E | I | 80/20 | 458 | 1,1 | 4,5 | 190 |
| 33 | F | I | 95/5 | 353 | 1,2 | 4,2 | 216 |
| 34 | F | VI | 95/5 | 330 | 0,4 | 0,8 | 249 |
| 35 | A | IX | 99/1 | 348 | 1,0 | 1,7 | |
| 36 | A | IX | 98/2 | 370 | 1,9 | 3,0 | |
| 37 | A | IX | 95/5 | 342 | 1,8 | 3,9 | |
| 38 | A | X | 95/5 | 344 | 2,8 | 3,4 | |

Tabelle 1 (Fortsetzung)

| Beispiel | PA-PI-Block copolymeres | Epoxidharz | Verhältnis PA-PI/Epoxidharz [Gew.-teile] | Flex-Life | Gewichtsänderung in % nach NMP-Lag. 1 h | 2 h |
|---|---|---|---|---|---|---|
| 39 | A | X | 90/10 | 347 | 2,3 | 3,7 |
| 40 | A | X | 75/25 | 376 | 3,0 | 3,4 |
| 41 | A | XI | 95/5 | 358 | 0,9 | 2,2 |
| 42 | G | I | 95/5 | 335 | 2,1 | 3,6 |
| 43 | G | I | 75/25 | 357 | 2,0 | 3,0 |
| 44 | G | IX | 99/1 | 344 | 1,1 | 1,2 |
| 45 | G | IX | 98/2 | 337 | 2,4 | 2,0 |
| 46 | G | IX | 95/5 | 361 | 3,3 | 4,2 |
| 47 | H | II | 98/2 | 384 | 0,9 | 1,4 |
| 48 | I | I | 90/10 | 344 | 0,0 | 0,2 |
| 49 | F | I | 97,5/2,5 | 360 | 0,2 | 0,4 |
| 50 | F | VII | 95,5/5 | 369 | 0,4 | 0,8 |
| 51 | J | IX | 95/5 | 459 | 1,3 | 1,6 |
| 52 | J | IX | 90/10 | 430 | 1,2 | 1,5 |
| 53 | A | XII | 95/5 | 371 | 2,7 | 1,6 |
| 54 | A | XII | 90/10 | 411 | 1,0 | 2,1 |
| 55 | A/G | VI | 47,5/47,5/5 | 340 | 2,0 | 2,3 |
| 56 | A/H | IV | 47,5/47,5/5 | 388 | 1,2 | 1,8 |
| 57 | A/H | VI | 47,5/47,5/5 | 327 | 1,7 | 3,8 |

Tabelle 1 (Fortsetzung)

| Beispiel | PA-PI-Block copolymeres | Epoxidharz | Verhältnis PA-PI/Epoxidharz [Gew.-teile] | Flex-Life | Gewichtsänderung in % nach NMP-Lag. 1 h | 2 h |
|---|---|---|---|---|---|---|
| 58 | A/G | III | 47,5/47,5/5 | 325 | 1,7 | 2,0 |
| 59 | A | I/X | 90/5/5 | 400 | 1,6 | 1,3 |
| 60 | A/G | III/IV | 45/45/5/5 | 364 | 1,2 | 2,4 |
| 61 | A | I/VII | 90/5/5 | 390 | 2,6 | 2,5 |
| 62 | A | I | 94/5/1*) | 415 | 0,7 | 1,5 |
| 63 | H | I | 94/5/1*) | 441 | 1,1 | 2,0 |
| 64 | A | I | 95/5**) | 426 | 0,6 | 2,1 |
| 65 | A | I | 95/5***) | 418 | 1,5 | 2,5 |

*) Das Gemisch enthält 1 Gew.-% BYK®S 706 als Verlaufsmittel, bezogen auf die gesamte Menge PA-PI, Epoxidharz und Verlaufsmittel.

**) Trocknung: Umluft-Temperatur =240°C; IR-Bestrahlung =45 Minuten.

***) Trocknung: Umluft-Temperatur =180°C; IR-Bestrahlung =60 Minuten.

Beispiel 66:

Herstellung und Eigenschaften eines Dreischichtlaminates aus PA-PI-Blockcopolymer/Epoxidharz-Zusammensetzungen

25 g PA-PI-Blockcopolymer D, 20 gew.-%ige Lösung in NMP, werden in einem Becherglas abgewogen und in einem Oelbad auf 120-140°C aufgewärmt. Nach dem die Lösung die Temperatur erreicht hat, werden 0,5 g Epoxidharz I zugegeben und so lange gerührt, bis das Epoxidharz vollständig gelöst ist.

Auf einer von der Fa. Gockel, München vertriebenen Anlage (Tisch mit normiertem Rakel) werden 150 µ starke Beschichtungen von der vorgehend beschriebenen, auf 50-60°C abgekühlten Lösung auf einer 35 µ starken Kupferfolie aufgetragen.

Die noch feuchten, beschichteten Folien werden an den Ecken fixiert und während 30 Minuten in einem auf 180°C beheizten Umflufttrockenschrank belassen. Nach dieser Trockendauer werden die beharzten Folien bei Raumtemperatur abgekühlt. Auf der kupferfolie bleibt eine Harzschicht von 25-30 µ zurück.

Die beharzten Kupferfolien werden auf einer Papierschneidemaschine zu 16 x 16 cm grosse Stücke zugeschnitten. Die zugeschnittenen, beschichteten Folien werden harzseitig aufeinander gelegt und zwischen zwei Polstern bei einer Temperatur von 240-260°C bei einem Druck von 40,8 bar verpresst. Nach 6 Minuten wird bei Presstemperatur entformt. Nach Abkühlen ist das flexible Laminat für die Bestimmung von Eigenschaften bereit.

Zur Bestimmung der elektrischen Eigenschaften wird in einem Aetzbad die oben und die unten liegende Kupferfolie weggeätzt. Die zurückbleibende Kunststoff-Folie wird mehrmals in destilliertem Wasser gewaschen und im Vakuumofen auf Gewichtskonstanz getrocknet. An dieser Folie werden die elektrischen Eigenschaften gemessen:

Durchschlagsfestigkeit (50 Hz) = 150 KV/mm tel quel

Spezifischer Durchgangswiderstand Ω (DIN 53482)

3,8 x $10^{15}$ Ohm x cm tel quel

3,8 x $10^{15}$ Ohm x cm nach 1 h Kochwasserlagerung

Dielektrischer Verlustfaktor tg δ und Dielektrizitätskonstante ε (DIN 53483)

| Hz | tg δ | Epsilon |
|---|---|---|
| 50 | 0,02 | 4 tel quel |
| 100 | 0,016 | 4 tel quel |
| 1000 | 0,011 | 3,9 tel quel |
| 10000 | 0,012 | 3,9 tel quel |
| 100000 | 0,024 | 3,8 tel quel |
| | | |
| 50 | 0,017 | 6,7 1 h Kochwasser |
| 100 | 0,017 | 6,7 1 h Kochwasser |
| 1000 | 0,017 | 6,6 1 h Kochwasser |
| 10000 | 0,013 | 6,5 1 h Kochwasser |
| 100000 | 0,031 | 6,3 1 h Kochwasser. |

Beispiel 67:

Kupferfolien - ED-Kupfer von 35 µ Dicke - werden auf der Treatmentseite mit einem Nassfilm von 200 µ folgender Zusammensetzung beschichtet: PA-PI-Blockcopolymeres K, 22 gew.-%ige Lösung in NMP, 10 Gew.-% Epoxidharz VI, bezogen auf festes PA-PI-Blockcopolymeres, und 0,15 Gew.-% BYK®S 706, bezogen auf die gesamte Lösung.

Nach 2-3 minutigem Abdunsten des Lösunsmittels bei Raumtemperatur wird die Beschichtung 10 Minuten bei 100°C und 30 Minuten bei 220°C getrocknet.

Zwei solcherart beschichtete Kupferfolien werden mit der Polymerschicht zueinander 2 Minuten bei 280°C mit einem Druck von 39,23 bis 49,04 bar verpresst und unter Druck auf Raumtemperatur abgekühlt.

Folgende Werte wurden für die Haftung der Kuperfolie ermittelt: Bei Raumtemperatur = 16,9 N/cm; bei 150°C = 16,9 N/cm und bei 250°C =7,7 N/cm.

Beispiel 68:

Analog Beispiel 66 werden 50 g PA-PI-Blockcopolymer L, 25 gew.-%ige Lösung in NMP, mit 1 g Epoxidharz I versetzt.

Die beharzten Kupferfolien werden bei einer Temperatur von 220-240°C und bei einem Druck von 39,23 bar 6 Minuten lang verpresst und die folgenden Eigenschaften bestimmt:

Durchschlagsfestigkeit (50 Hz) = 143 KV/mm (tel quel) spezifischer Durchgangswiderstand IEC 93 = $5,3 \cdot 10^{15}$ Ohm x cm (tel quel).

## Patentansprüche

1. Gemische, enthaltend
   (a) ein Epoxidharz mit mindestens zwei Epoxidgruppen im Molekül und
   (b) ein in einem polaren aprotischen Lösungsmittel lösliches Polyamid-Polyimid(PA-PI)-Blockcopolymer in einem Gewichtsverhältnis von a:b von 1:1 bis 1:200.

2. Gemische gemäss Anspruch 1, worin das Gewichtsverhältnis von a:b 1:4 bis 1:10, insbesondere 1:5 bis 1:50, beträgt.

3. Gemische gemäss Anspruch 1, enthaltend als Epoxidharz (a) einen Polyglycidylether eines Phenols oder Novolaks, Triglycidylisocyanurat, N,N,O-Triglycidyl-p-aminophenol ein Poly(N-glycidyl)-derivat eines aromatischen Amins oder ein cycloaliphatisches Epoxidharz.

4. Gemische gemäss Anspruch 1, enthaltend als Epoxidharz (a) einen Diglycidylether eines Bisphenols oder Novolaks, o,o'-Diallylbisphenol A-diglycidylether, Triglycidylisocyanurat, N,N-O-Triglycidyl-p-aminophenol, Bis-[4-(diglycidylamino)-phenyl]-methan, Tetra-(p-glycidyloxyphenyl)-ethan oder 3,4-Epoxycyclohexylmethyl-3,4-epoxycyclohexancarboxylat.

5. Gemische gemäss Anspruch 1, enthaltend ein PA-PI-Blockcopolymer (b) mit einem mittleren Molekulargewicht $\overline{M}_n$ von 1'000 bis 50'000, das wiederkehrende Einheiten der Formel II

$$\{PA\text{-}PI\} \qquad (II)$$

enthält, worin PA für einen Polyamidblock mit einem mittleren Molekulargewicht $\overline{M}_n$ von 300-20'000 steht, enthaltend mindestens eine (wiederkehrende) Einheit der Formel III

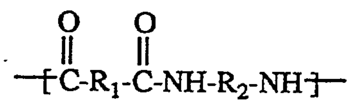 (III),

worin $R_1$ ein Rest der Formeln $-C_nH_{2n}-$, 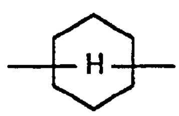 , 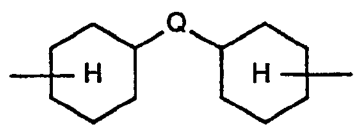 ,

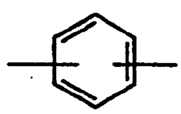 , 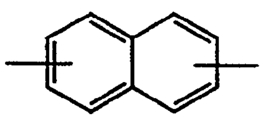 oder 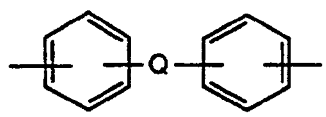 ist, und $R_2$ einen Rest der Formeln $-C_nH_{2n}-$, 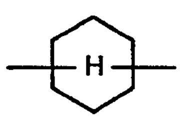 , 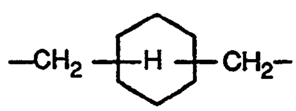 ,

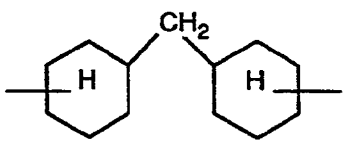 , 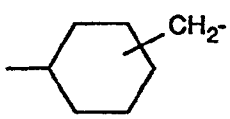 , 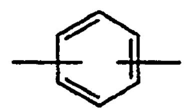 , 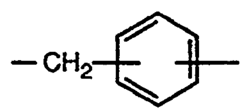 ,

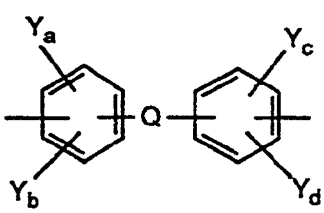 , 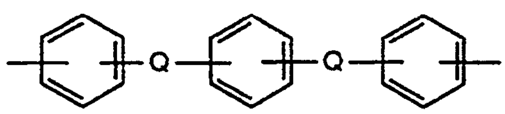 oder

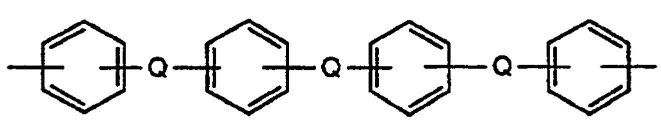

bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkyl bedeuten, und PI für einen Polyimidblock mit einem mitleren Molekulargewicht $\overline{M}_n$ von 300-20'000 steht, enthaltend mindestens eine (wiederkehrende) Einheit der Formel IV

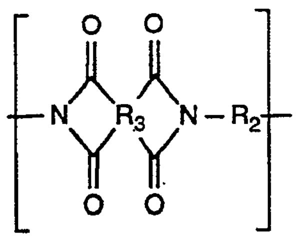

(IV),

worin $R_3$

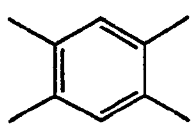

,

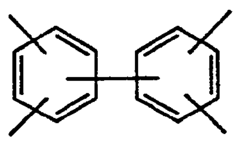

oder

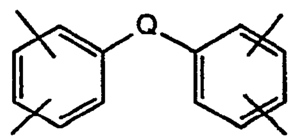

ist, und Q und $R_2$ die oben angegebene Bedeutung haben, mit der Massgabe, dass 25-100 Mol-% aller Brückenglieder $R_2$

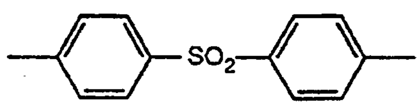

und/oder

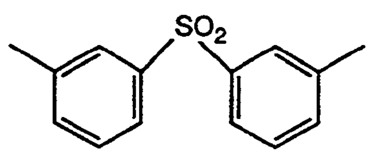

bedeuten, und der (cyclo-)aliphatische Anteil an Brückengliedem $R_2$ nicht mehr als 10 Mol-% beträgt.

**6.** Gemische gemäss Anspruch 1, enthaltend ein PA-PI-Blockcopolymer (b) mit einem $\overline{M}_n$ von 1'000 bis 50'000 und wiederkehrenden Struktureinheiten der Formel II

$$\left[ PA\text{-}PI \right] \quad (II),$$

worin im Polyamidblock PA und im Polyimidblock PI ein Verhältnis von Amid- zu Imidgruppen von etwa 4:1 bis 1:4 vorliegt und das Blockcopolymer in den Polyimidblöcken einen Gehalt von mindestens 2 Mol.%, bezogen auf den Gehalt an allen Carbonsäureresten im Blockcopolymer, an Resten der Formel

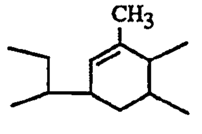

aufweist.

**7.** Gemische gemäss Anspruch 6, enthaltend ein PA-PI-Blockcopolymer aus Kombinationen von Blöcken der Formeln Xb mit IXa und/oder IXc oder der Formeln IXb mit Xa und/oder Xc

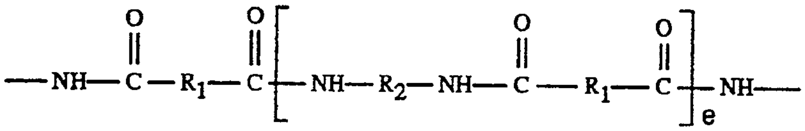 (IXa),

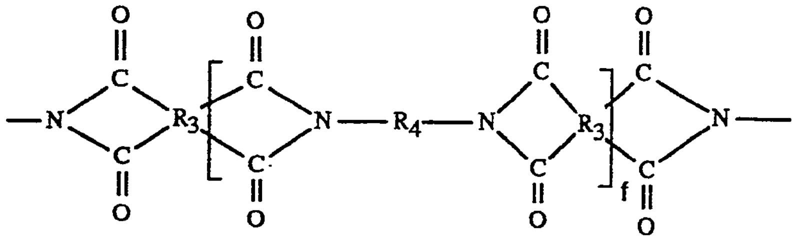 (IXb),

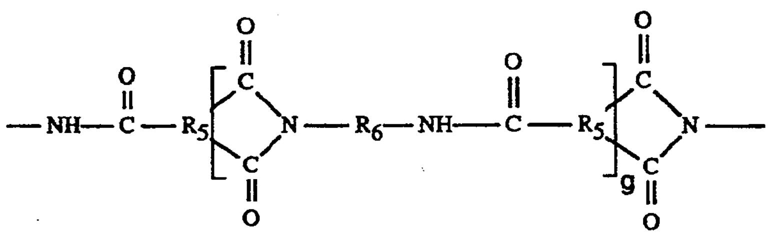 (IXc),

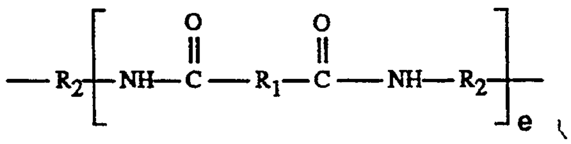 (Xa),

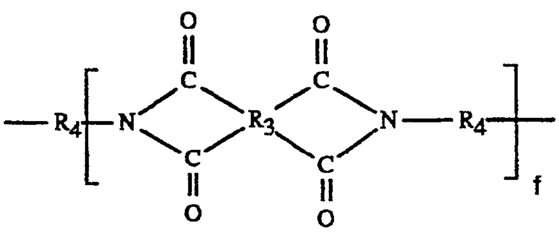 (Xb),

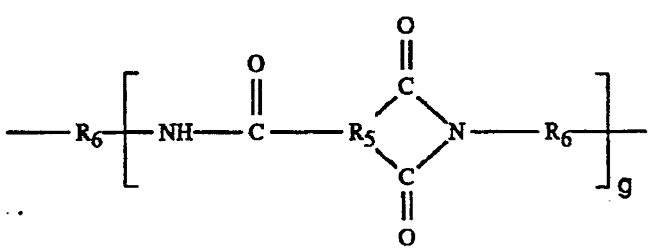 (Xc),

worin die Indizes e, f und g unabhängig voneinander ganze Zahlen von 1 bis 100 sind, $R_1$ ein Rest der Formeln $-C_nH_{2n}-$,

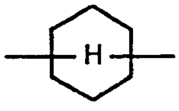 , 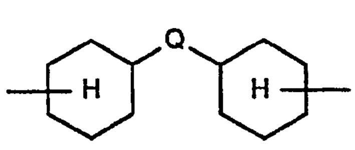 ,

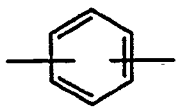, 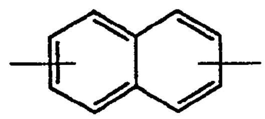 oder 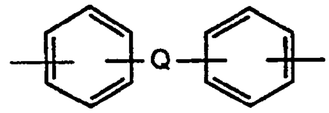 ist, und $R_2$ einen

Rest der Formeln $-C_nH_{2n}-$, 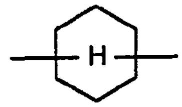, 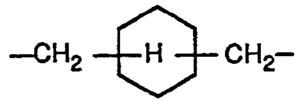,

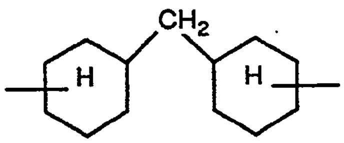, 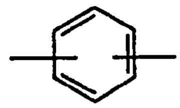, 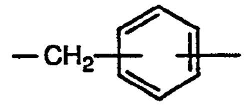,

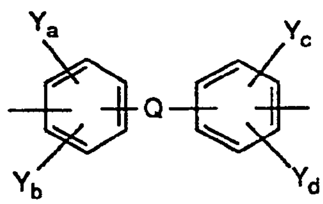, 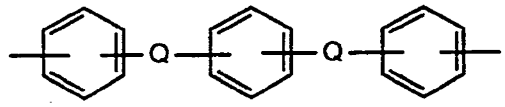

oder

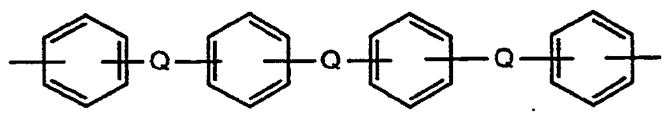

bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkyl bedeuten,
$R_3$ ein Rest der Formeln

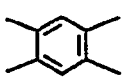, 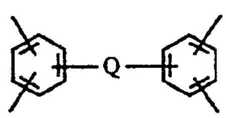, 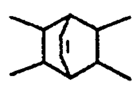, 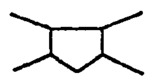 oder 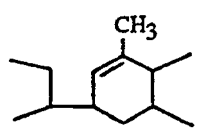 ist,

worin Q eine direkte Bindung darstellt oder $-CH_2-$, $-CH_2CH_2-$, $-CH(CH_3)-$, $-C(CH_3)_2-$, $-C(CF_3)_2-$, -O-, -S-, $-SO_2-$ oder -CO- bedeutet, $R_5$ ein Rest der Formel

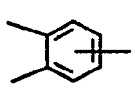

ist, und $R_4$ und $R_6$ unabhängig voneinander eine der für $R_2$ definierten Bedeutungen besitzen, mit der Massgabe, dass 25-100 Mol % aller Reste $R_3$ die Formel

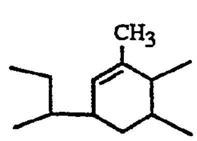

aufweisen.

8. Gemische gemäss Anspruch 7, enthaltend ein PA-PI-Blockcopolymer aus Kombinationen von Blöcken der

Formeln IXa mit Xb und/oder Xc oder der Formeln IXb mit Xa und/oder Xc oder der Formeln IXc mit Xa und/oder Xb, mit der anderen Massgabe, dass 10-100 Mol %, bevorzugt 25-100 Mol %, insbesondere 50-100 Mol %, aller Reste $R_2$, $R_4$ und $R_6$, bezogen auf die Gesamtmenge dieser Reste, die Formel

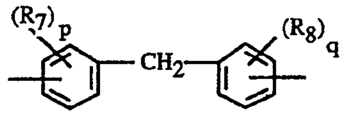

aufweisen, worin p 1 oder 2 und q Null, 1 oder 2 ist, $R_7$ und $R_8$ je ein $C_1$-$C_8$-Alkyl bedeuten oder worin je zwei zueinander ortho-ständige Reste $R_7$ und $R_8$ jeweils zusammen eine Alkylengruppe bilden.

9. Gemische gemäss Anspruch 7, enthaltend ein PA-PI-Blockcopolymer aus Kombinationen von Blöcken der Formeln IXa mit Xb und/oder Xc oder der Formeln IXb mit Xa und/oder Xc oder der Formeln IXc mit Xa und/oder Xb, mit der anderen Massgabe, dass 25-100 Mol % aller Reste $R_2$, $R_4$ und $R_6$, bezogen auf die Gesamtmenge dieser Reste, die Formel

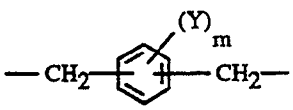 und/oder 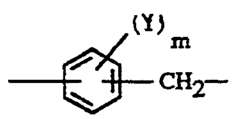

aufweisen, worin Y ein $C_1$-$C_8$-Alkyl oder Halogen bedeutet und m für eine Zahl von 0 bis 4 steht.

10. Gemische gemäss Anspruch 1, enthaltend zusätzlich ein Verlaufsmittel.

11. Organische Lösung, enthaltend ein Gemisch gemäss Anspruch 1, gelöst in einem polaren aprotischen Lösungsmittel.

12. Einfach beschichtete Laminate, vorzugsweise Metallaminate und insbesondere Kupferlaminat, enthaltend als Beschichtung ein Gemisch gemäss Anspruch 1.

13. Laminate, vorzugsweise Metallaminate und insbesondere Kupferlaminate, in denen die Verklebung aus einem Gemisch, enthaltend ein Epoxidharz (a) und ein lösliches PA-PI-Blockcopolymer (b) gemäss Anspruch 1, besteht.

14. Laminate gemäss Anspruch 13, in denen zwei einseitig mit dem Gemisch gemäss Anspruch 1 beschichtete Metallfolien mit der beschichteten Seite zueinander unter Druck und Wärme verpresst sind.